(19) Europäisches Patentamt
European Patent Office
Office européen des brevets

(11) EP 3 994 796 B1

(12) EUROPEAN PATENT SPECIFICATION

(45) Date of publication and mention
of the grant of the patent:
05.11.2025 Bulletin 2025/45

(21) Application number: 19742564.8

(22) Date of filing: 18.07.2019

(51) International Patent Classification (IPC):
H03H 17/06 $^{(2006.01)}$     G06F 9/30 $^{(2018.01)}$
H03H 17/02 $^{(2006.01)}$

(52) Cooperative Patent Classification (CPC):
H03H 17/06; H03H 17/0657; H03H 17/0664;
H03H 2017/0298; H03H 2218/04

(86) International application number:
PCT/EP2019/069379

(87) International publication number:
WO 2021/008711 (21.01.2021 Gazette 2021/03)

(54) **ADVANCED FINITE IMPULSE RESPONSE SYSTEM AND METHOD FOR REAL COEFFICIENTS AND COMPLEX DATA**

FORTSCHRITTLICHES ENDLICHES IMPULSANTWORTSYSTEM UND VERFAHREN FÜR REELLE KOEFFIZIENTEN UND KOMPLEXE DATEN

SYSTÈME ET PROCÉDÉ DE RÉPONSE IMPULSIONNELLE FINIE AVANCÉE POUR DES COEFFICIENTS RÉELS ET DES DONNÉES COMPLEXES

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(43) Date of publication of application:
11.05.2022 Bulletin 2022/19

(73) Proprietor: Huawei Technologies Co., Ltd.
Longgang District
Shenzhen,
Guangdong 518129 (CN)

(72) Inventors:
• BAR, Moti
80992 Munich (DE)
• RABINOVITCH, Alexander
80992 Munich (DE)
• ARTSI, Amir
80992 Munich (DE)
• GAL, Avraham
80992 Munich (DE)

(74) Representative: Körber, Martin Hans
Mitscherlich PartmbB
Patent- und Rechtsanwälte
Karlstraße 7
80333 München (DE)

(56) References cited:
WO-A1-2016/178774     US-A1- 2008 244 220
US-A1- 2014 219 577     US-A1- 2017 269 832

**Description**

BACKGROUND

The present invention, in some embodiments thereof, relates to digital signal processing and, more specifically, but not exclusively, to systems and methods for applying digital Finite Impulse Response (FIR) filters to digital signals.

Filtration is a common basic operation performed in a variety of signal processing applications in order to remove or extract certain components or features of a signal, for example, to clean up noises, detect saliencies, compress or expand data, and/or the like. Computationally efficient systems and/or methods are sought to quickly perform digital signal filtering within a reasonable amount of time using a reasonable amount of computational resources (i.e., memory and/or processing hardware). For example, digital signal processors such as employed in wireless communications networks need to have high data throughput and efficient energy consumption to process different filters and/or filtering operation types on large volumes of different signals inputs.

In one common digital processing approach, filtering may consist a type of filters known as Finite Impulse Response (FIR) filters. FIR filter is a filter whose impulse response is of finite duration, i.e. it comprises a finite number of non-zero samples. FIR filters are widely used in digital signal processing. Their applications often demand high-speed computation. To satisfy this requirement, efficient filter architectures as well as advanced integrated circuits technologies may be needed.

Symmetric FIR filters with real coefficients and complex data, are frequently used in digital signal processing. A symmetric FIR filter, as is readily implied by the term, is a FIR filter whose elements are mirror images of one another around its center, i.e. the first element equals to the last element, the second element equals to the element that is second to last, and so forth. In scenarios where a single system may be required to support multiple Symmetric FIR types, a challenge arises as to how an efficient solution is assigned for each supported type requirement.

US 2017/269832 A1 relates to a system and method for symmetrical filtering of an input string that includes loading into at least one vector-register, in a single read cycle, a subset of right-side data elements and a subset of left-side data elements of the input string.

SUMMARY

It is an object of the present invention to provide a system, a method, and a computer program product for advanced finite impulse response (FIR) filtration of signals with real coefficients and complex data.

The foregoing and other objects are achieved by the features of the independent claims. Further implementation forms are apparent from the dependent claims, the description and the figures.

According to a first aspect, a system for applying a Finite Impulse Response (FIR) filter according to independent claim 1 is disclosed.

According to a second aspect, a method for applying a Finite Impulse Response (FIR) filter according to independent claim 11 is disclosed.

The systems and methods for FIR filtering as disclosed herein provide solution to signal processing using symmetric FIR filters, being able to both taking advantage of the symmetry property for yielding optimal performance, while having flexibility to handle different FIR filter types and/or arbitrary size inputs, for example, half-band, decimation and/or interpolation by integer factors of different magnitudes, odd and/or even number of filter coefficients, etc.

Rather than handling only single elements of the FIR filter and/or signal at a time, the FIR filtering systems and/or methods in accordance with the present disclosure entail use of vector addition and multiplication for calculation of multiple components or element portions of the filtered signal at once, as well as simultaneous processing of at least two FIR filter coefficients in each cycle, whereby improving computational efficiency.

Implementation of the disclosed FIR filtering systems and/or methods requires merely negligible additional hardware and is of relatively low complexity and improved performance in comparison to pre-existing approaches and implementations of digital signal processing systems, for example, in terms of calculation speed and/or data throughput rate, efficiency of resources usage such as computing power, storage space, and/or energy consumption, and/or the like.

In a further implementation form of the first and second aspects, the first and second dual left-shift vectors comprise elements of the first sub-vector as obtained responsive to being left-shifted once and twice respectively, and the first and second dual right-shift vectors comprise elements of the second sub-vector as obtained responsive to being right-shifted once and twice respectively.

In a further implementation form of the first and second aspects, the FIR filter is symmetric and having a first length, the first sub-vector and the second sub-vector are obtained at an interval of the first length, and a number of iterations in which the third sub-vector and the fourth sub-vector are obtained is determined as a function of the first length.

In a further implementation form of the first and second aspects, the first sub-vector and the second sub-vector are each having a second length, wherein a number of iterations in which the first sub-vector and the second sub-vector are obtained is determined as a function of a ratio between a length of the signal and the second length.

In a further implementation form of the first and second aspects, the first and second dual left-shift vectors are obtained by retrieving a first element of the third sub-vector at a rightward offset per a first left-shift parameter specified, and a second element of the third sub-vector at a rightward offset per a second left-shift parameter specified.

In a further implementation form of the first and second aspects, the first and second dual right-shift vectors are obtained by retrieving a first element of the fourth sub-vector at a leftward offset per a first right-shift parameter specified, and a second element of the fourth sub-vector at a leftward offset per a second right-shift parameter specified.

In a further implementation form of the first and second aspects, two multipliers from the FIR filter are obtained at a j-th iteration by retrieving elements at (2j-1)-th and (2j)-th locations thereof.

In a further implementation form of the first and second aspects, the FIR filter is a half-band filter, and the filtered data is obtained by performing the following: obtaining a first subsequence of the signal comprising elements at even locations thereof; obtaining a second subsequence of the signal comprising elements at odd locations thereof; modifying the FIR filter by selection of every non-zero elements thereof; applying the modified filter on each of the first and second subsequences to obtain even and odd filtered data; and multiplexing the even and odd filtered data by alternate selection of elements therefrom.

In a further implementation form of the first and second aspects, the filtered data is obtained by performing the following: receiving an additional input of a decimation factor D; obtaining D subsequences of the signal each comprising elements thereof at intervals of D, each of the D subsequences starting at different element selected from the first D elements of the signal; and for each of the D subsequences, performing in each of a plurality of iterations said extracting first, second, third and fourth sub-vectors, said left shifting and replacing elements of the first sub-vector by elements of the third sub-vector for obtaining first and second dual left-shift vectors, said right shifting and replacing elements of the second sub-vector by elements of the fourth sub-vector for obtaining first and second dual right-shift vectors, and further performing the steps of: obtaining from each of D phases of the FIR filter first and second multipliers, multiplying a first sum vector obtained from adding the first dual left-shift vector to the first dual right-shift vector by the first multiplier, and multiplying a second sum vector obtained from adding the second dual left-shift vector to the second dual right-shift vector by the second multiplier; and adding to the accumulated vector comprising portions of the filtered data a sum of the multiplication results obtained for each of the D phases.

In a further implementation form of the first and second aspects, the filtered data is obtained by performing the following: receiving an additional input of an interpolation factor L; performing in each of a plurality of iterations said extracting first, second, third and fourth sub-vectors, said left shifting and replacing elements of the first sub-vector by elements of the third sub-vector for obtaining first and second dual left-shift vectors, said right shifting and replacing elements of the second sub-vector by elements of the fourth sub-vector for obtaining first and second dual right-shift vectors, and further performing the steps of: obtaining from each of L phases of the FIR filter first and second multipliers, multiplying a first sum vector obtained from adding the first dual left-shift vector to the first dual right-shift vector by the first multiplier, and multiplying a second sum vector obtained from adding the second dual left-shift vector to the second dual right-shift vector by the second multiplier; and for each of the L phases, adding to a phase accumulated vector comprising portions of the filtered data a sum of the multiplication results obtained for the phase; and multiplexing the filtered data obtained at the L phase accumulated vectors by alternate selection of elements therefrom.

Unless otherwise defined, all technical and/or scientific terms used herein have the same meaning as commonly understood by one of ordinary skill in the art to which the invention pertains. Although methods and materials similar or equivalent to those described herein can be used in the practice or testing of embodiments of the invention, exemplary methods and/or materials are described below. In case of conflict, the patent specification, including definitions, will control. In addition, the materials, methods, and examples are illustrative only and are not intended to be necessarily limiting.

BRIEF DESCRIPTION OF THE SEVERAL VIEWS OF THE DRAWINGS

Some embodiments of the invention are herein described, by way of example only, with reference to the accompanying drawings. With specific reference now to the drawings in detail, it is stressed that the particulars shown are by way of example and for purposes of illustrative discussion of embodiments of the invention. In this regard, the description taken with the drawings makes apparent to those skilled in the art how embodiments of the invention may be practiced.

In the drawings:

FIG. 1A is a schematic illustration of an exemplary processing circuitry for implementing a digital FIR filter, useful to help understand some embodiments of the present invention;

FIG. 1B is a schematic illustration of an exemplary processing circuitry for implementing a symmetric digital FIR filter, useful to help understand some embodiments of the present invention;

FIGS. 2A and 2B are respective exemplary computer program code and schematic illustration of signal data and symmetric FIR filter coefficients processing performed thereby, in accordance with some embodiments of the present invention;

FIG. 3 is a schematic illustration of an exemplary processing instruction for obtaining a dual right-shift vectors pair, in accordance with some embodiments of the present invention;

FIG. 4 is a schematic illustration of an exemplary processing instruction for dual addition of two vectors pairs and usage thereof in multiplication by two FIR filter coefficients, in accordance with some embodiments of the present invention;

FIG. 5A is a flowchart of a method of signal processing by symmetric FIR filtering, in accordance with some embodiments of the present invention;

FIG. 5B is a flowchart of a method of signal processing by symmetric FIR filtering and decimation, in accordance with some embodiments of the present invention;

FIG. 5C is a flowchart of a method of signal processing by half-band symmetric FIR filtering, in accordance with some embodiments of the present invention; and

FIG. 5D is a flowchart of a method of signal processing by symmetric FIR filtering and interpolation, in accordance with some embodiments of the present invention.

## DETAILED DESCRIPTION

The present invention, in some embodiments thereof, relates to digital signal processing and, more specifically, but not exclusively, to systems and methods for advanced finite impulse response (FIR) filtration of signals with real coefficients and complex data.

An aspect of some embodiments of the present invention relate to methods, systems, and/or an apparatus for applying digital Finite Impulse Response (FIR) filters to digital signals. In each of a plurality of iterations, a first and second sub-vectors, a third sub-vector succeeding the first sub-vector and a fourth sub-vector preceding the second sub-vector, are extracted from a plurality of elements representing sequential values of a signal and a FIR filter received. A first and second dual left-shift vectors are obtained by shifting left the first sub-vector by at least one element and replacing elements at right-most locations thereof by elements of the third sub-vector. A first and second dual right-shift vectors are obtained by shifting right the second sub-vector by at least one element and replacing elements at left-most locations thereof by elements of the fourth sub-vector. A sum of vectors pair, obtained as an outcome of multiplying a sum of the first dual left-shift vector and the first dual right-shift vector with a multiplier from the FIR filter, and multiplying a sum of the second dual left-shift vector and the second dual right-shift vector with another multiplier from the FIR filter, is added to an accumulated vector comprising portions of the filtered data.

The FIR filtering systems and methods in accordance with the present disclosure improve performance in comparison to pre-existing implementations and support various FIR use cases, including: symmetric filter coefficients, symmetric filter coefficients with decimation by an integer factor, symmetric filter coefficients with interpolation by an integer factor, half-band filters, and/or the like. The FIR filtering systems and methods as disclosed herein are adapted for handling inputs of an arbitrary size and/or different types of FIR filters, for example, odd and/or even filter sizes, different factors of decimation and/or interpolation, and/or the like, without degradation in performance optimality.

Rather than handling only single elements of the FIR filter and/or signal at a time, the FIR filtering systems and/or methods in accordance with the present disclosure entail use of vector addition and multiplication for calculating multiple components or element portions of the filtered signal at once, as well as simultaneous processing of at least two FIR filter coefficients in each cycle, whereby improving computational efficiency.

Implementation of the disclosed FIR filtering systems and/or methods requires merely negligible additional hardware and is of relatively low complexity and improved performance in comparison to pre-existing approaches and implementations of digital signal processing systems, for example, in terms of calculation speed and/or data throughput rate, efficiency of resources usage such as computing power, storage space, and/or energy consumption, and/or the like.

Before explaining at least one embodiment of the invention in detail, it is to be understood that the invention is not necessarily limited in its application to the details of construction and the arrangement of the components and/or methods set forth in the following description and/or illustrated in the drawings and/or the Examples. The invention is capable of other embodiments or of being practiced or carried out in various ways.

The present invention may be a system, a method, and/or a computer program product. The computer program product may include a computer readable storage medium (or media) having computer readable program instructions thereon for causing a processor to carry out aspects of the present invention.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing.

Computer readable program instructions described herein can be downloaded to respective computing/processing devices from a computer readable storage medium or to an external computer or external storage device via a network, for example, the Internet, a local area network, a wide area network and/or a wireless network.

The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present invention.

Aspects of the present invention are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

It is noted that the term *taps* as used herein may refer either to coefficients of a FIR filter or to signal components multiplied thereby.

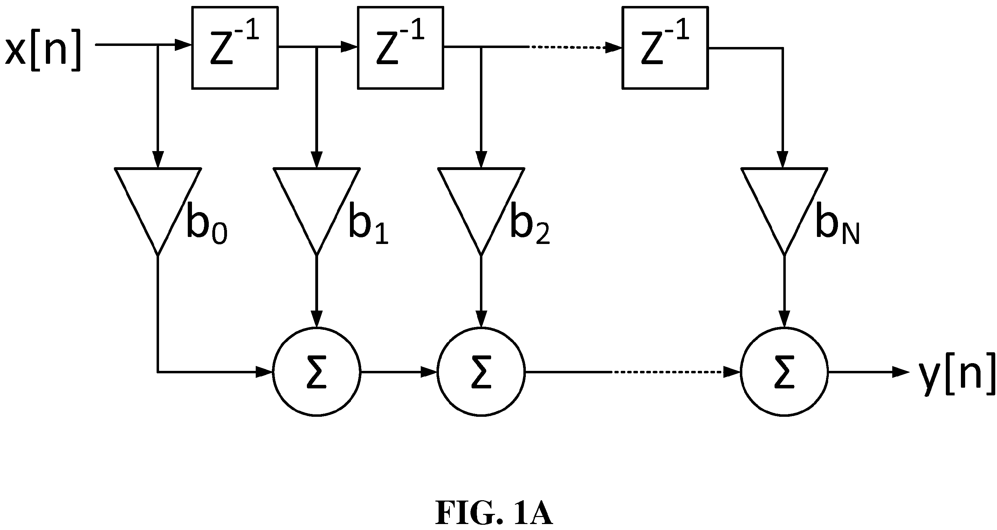

Reference is now made to FIG. 1A, which is a schematic illustration of an exemplary processing circuitry for implementing a digital FIR filter, useful to help understand some embodiments of the present invention.

As shown in Fig. 1A, for a digital FIR filter of order N (i.e., a filter having N+1 coefficients), each value of the output sequence is a weighted sum of the most recent input values, as may be expressed in the formula (1) as follows:

$$(1) \qquad y[n] = b_0 x[n] + b_1 x[n-1] + \cdots + b_N x[N-n]$$

$$= \sum_{i=0}^{N} b_i \cdot x[n-i]$$

where:

    $x[n]$ is the input signal,
    $y[n]$ is the output signal, and
    $b_i$ is a coefficient of the filter and the value of the impulse response at the *i*-th instant for

$$0 \le i \le N.$$

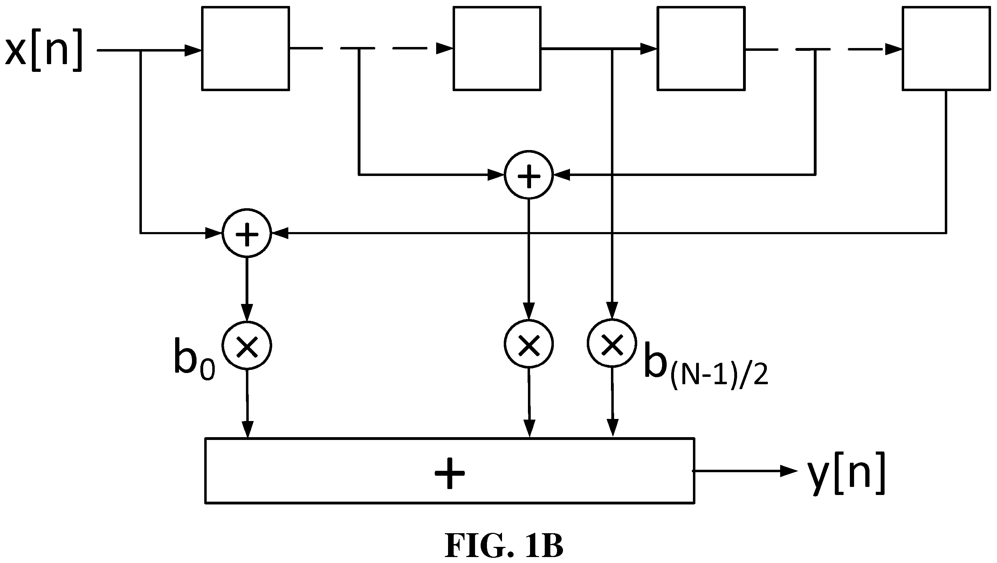

Reference is now made to FIG. 1B, which is a schematic illustration of an exemplary processing circuitry for implementing a symmetric digital FIR filter, useful to help understand some embodiments of the present invention.

In a symmetric filter, coefficients at opposite locations relative to its center are equal to one another, namely for an order N, $b_0 = b_N$, $b_1 = b_{N-1}$, and so forth.

Using this symmetry property, an efficient calculation may be performed as in formula (2) as follows:

$$(2) \qquad y[n] = b_0(x[n] + x[n-N]) +$$

$$b_1(x[n-1] + x[n-(N-1)]) + \cdots$$

As shown in Fig. 1B, this calculation may be implemented by inserting a pre-adder function in front of the multiplier tree, thus effectively doubling the number of taps that may be handled by the processing circuitry. By exploiting the symmetry property, half of the multiplication operations as would be performed in an implementation such as shown in Fig. 1A, may be saved. As shown in Fig. 1B, for symmetric FIR filters of length N, an efficient implementation may use only N/2 or $(N + 1)/2$ multipliers, for even or odd N respectively, rather than using N multipliers, as in Fig. 1A.

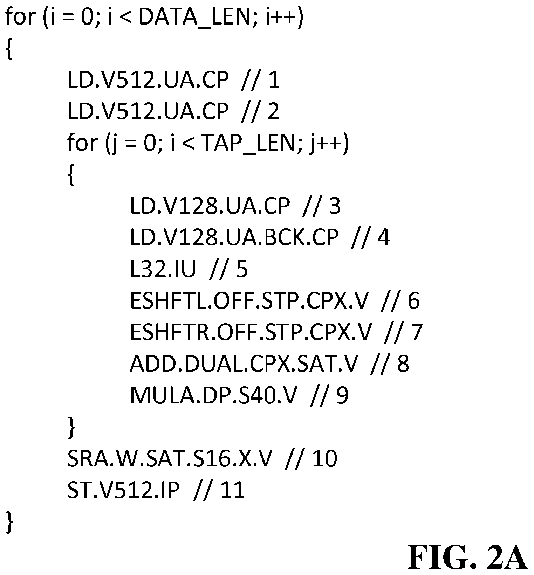

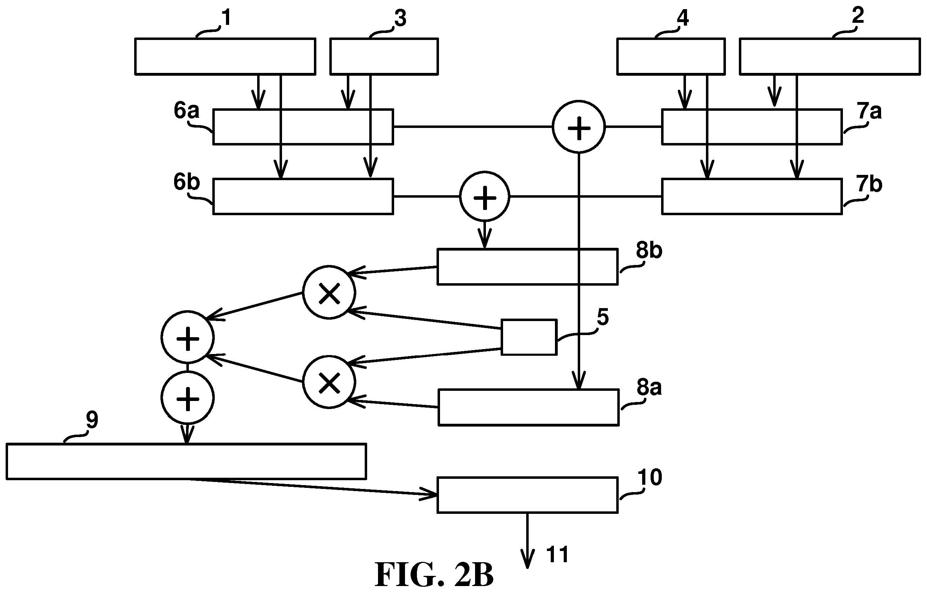

Reference is now made to FIG. 2A, which is an exemplary computer program code for performing signal data and symmetric FIR filter coefficients processing, in accordance with some embodiments of the present invention. Reference is also made to FIG. 2B, which is a schematic illustration of the signal data and symmetric FIR filter coefficients processing being performed by the exemplary computer program code of Fig. 2A, in accordance with some embodiments of the present invention.

In some exemplary embodiments, storage units capable of accommodating a predetermined number of signal data elements may be used for serially processing the signal in segments. For example, as in the exemplary code shown in FIG. 2A, storage units capable of accommodating 16 elements of signal data each, may be employed, wherein each element may be a complex number in 32-bit representation (e.g., a pair of two real numbers in 16-bit representation each), and each storage unit may consist of 512 bits total. The external loop may iterate for DATA_LEN/16 times, where DATA_LEN denotes a total length of the signal data being processed. However, as can be readily understood by a person skilled in the art, the FIR filtering systems and methods disclosed herein are not limited in such manner, and may employ data storage units and/or data representation formats of any other dimensions as well.

As shown in FIG. 2A, at the beginning of the external loop, two sub-vectors comprising 16 elements of the signal data each, may be loaded to respective 512-bit storage units. The loading may be performed using an exemplary instruction LD.V512.UA.CP, as illustrated in Fig. 2A, which may be further configured to return a pointer to an element of the respective loaded vector at a left-most location thereof. The first sub-vector may comprise sequential elements of the signal data, starting at a location subsequent to a last series of 16 elements processed during previous iterations, whereas the second sub-vector may comprise a sequence of signal data elements starting at a location removed by TAP_LEN+1 elements further ahead of a first element of the first sub-vector, where TAP_LEN denotes a total length of the FIR filter (i.e., number of coefficients) being processed.

For example, the first sub-vector may comprise elements of the signal data at locations [n ... n+15] and the second sub-vector may comprise elements of the signal data at locations [n+1+TAP_LEN ... n+16+TAP_LEN] respectively. The first and second sub-vectors are illustrated in FIG. 2B, denoted therein as 1 and 2 respectively.

Once the first and second sub-vectors are loaded, the internal loop may iterate for TAP_LEN/4 times, as in the exemplary code shown in Fig. 2A. The division by 4 emanates from the code section at hand being aimed at processing 2 pairs of signal data segments in each cycle, the segments in each pair being multiplied by either one of two taps at opposing sides of the FIR filter around its center, which, due to the symmetry property, are identical and therefore it suffices to use only the first of the two. It is to be understood, however, that other designs may be applicable, for example, 4 pairs of signal data segments may be multiplied by 4 taps in each cycle, thereby decreasing the number of cycles by a factor of 2, and so forth.

At the beginning of the internal loop, a third sub-vector that succeeds the first sub-vector, and a fourth sub-vector that precedes the second sub-vector, may be loaded to storage units of a predetermined length. For example, as in the exemplary code shown in Fig. 2A, the third and fourth sub-vectors may comprise 4 elements of the signal data each, accommodated by respective storage units of 128 bits, wherein the 4 elements of the third sub-vector may be next to the 16 elements of the first sub-vector, and the 4 elements of the fourth sub-vector may be prior to the 16 elements of the second sub-vector, all with respect to relative locations of which elements within the original signal data.

To illustrate, in case that the first and second sub-vectors comprise elements of the signal data at locations [n ... n+15] and [n+1+TAP_LEN ... n+16+TAP_LEN] respectively, then the third and fourth sub-vectors may comprise elements of the signal data at locations [n+16 ... n+19] and [n+TAP_LEN-3 ... n+TAP_LEN] respectively. It is to be understood, nevertheless, that the present invention is not limited in such manner, and data storage units of any other size may be used for accommodation of the third and fourth sub-vectors. The third and fourth sub-vectors are illustrated in FIG. 2B, denoted therein as 3 and 4 respectively.

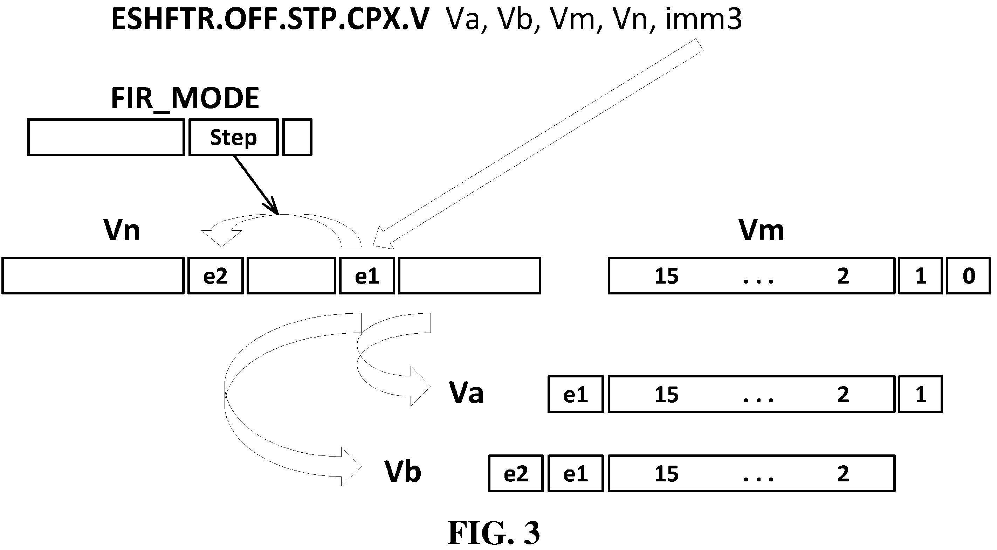

As illustrated in Fig. 2A, loading of the third sub-vector may be performed using an exemplary LD.V128.UA.CP instruction, similarly as with the exemplary LD.V512.UA.CP instruction used for loading either one of the first and second sub-vectors. As further illustrated in Fig. 2A, loading of the fourth sub-vector may be performed using an exemplary LD.V128.UA.BCK.CP instruction, which may be further configured to return a pointer to an element of the respective loaded vector at a right-most location thereof, rather than the left-most location. The rational for having the pointer pointing to the right end of the fourth sub-vector rather than to its left end may be further clarified in view of the detailed description and explanation hereinafter of exemplary shift right instruction for obtaining a dual right-shift vectors pair illustrated in Fig. 3.

Next, two taps from the FIR filter, located subsequently to the last taps processed most recently, may be loaded. For example, in case of a FIR filter of order N with taps denoted as h[0], h[1], ... h[N], the two taps h[2j] and h[2j+1] may be loaded for each respective value of j in {0, 1, ... [(N+1)/4]-1}. As shown in FIG. 2A, each of the two taps may be a real number in 16-bit representation, such that the two taps may be accommodated within a storage unit of 32 bits total, which loading of the two taps thereto may be performed using an exemplary L32.IU instruction. The taps loaded are illustrated in FIG. 2B, denoted therein as 5.

Then, a first and second dual left-shift vectors may be obtained from the first and third sub-vectors using a shift left instruction, in accordance with some exemplary embodiments of the present invention. Similarly, a first and second dual right-shift vectors may be obtained from the second and fourth sub-vectors using a shift right instruction, in accordance with some exemplary embodiments of the present invention.

In some exemplary embodiments, a shift left instruction may be configured for shifting left the first sub-vector by one and two elements, respectively, and replace elements thus shifted to the one or two right-most locations of the first sub-vector with one or two elements retrieved from the third sub-vector, at locations specified by offset and step parameters provided.

In some exemplary embodiments, a shift right instruction may be configured for shifting right the second sub-vector by one and two elements, respectively, and replace elements thus shifted to the one or two left-most locations of the second sub-vector with one or two elements retrieved from the fourth sub-vector, at locations specified by offset and step parameters provided. A detailed description of an exemplary shift right instruction is provided herein in FIG. 3 and accompanying text.

As an illustrative example, assuming that the first, second, third, and fourth sub-vectors comprise elements of the signal data at the following respective locations: [n ... n+15], [n+1+TAP_LEN ... n+16+TAP_LEN], [n+16 ... n+19], and [(n+TAP_LEN-3 ... n+TAP_LEN], then, if using an offset of 0 and step of 1, as described herein, the first and second dual left-shift vectors may comprise elements of the signal data at locations [n+1 ... n+16] and [n+2 ... n+17] respectively, and the first and second dual right-shift vectors may comprise elements at locations [n+TAP_LEN ... n+15+TAP_LEN] and [n+TAP_LEN-1 ... n+14+TAP_LEN] respectively.

To further illustrate, in case that the index parameter n is initially set to -1, then a first execution of both the external and internal loop yields first and second dual left-shift vectors comprising the signal elements at locations [0 ... 15] and [1 ... 16], and first and second dual right-shift vectors comprising the signal elements at locations [TAP_LEN-1 ... TAP_LEN+14] and [TAP_LEN-2 ... TAP_LEN-13], respectively.

The first and second dual left-shift vectors, and first and second dual right-shift vectors, are illustrated in FIG. 2B and denoted therein 6a, 6b, 7a, and 7b, respectively.

Next, as shown in FIG. 2A, a dual add instruction, in accordance with some exemplary embodiments of the present invention, may be performed. A dual add instruction may be configured for obtaining a first and second sum vectors, by addition of the first dual left-shift vector and first dual right-shift vector, and by addition of the second dual left-shift vector and second dual right-shift vector, respectively. The first and second sum vectors are illustrated in FIG. 2B and denoted therein 8a and 8b, respectively.

Next, as shown in FIG. 2A, a multiplication and addition operation may be performed, by which the first sum vector may be multiplied by one of the two taps, the second sum vector may be multiplied by the other of the two taps, and the multiplication outcomes may be added together and into a storage unit accommodating an accumulated vector of results from previous cycles of the internal loop. The storage unit may be configured for accommodating a wide vector of a sufficient length as may be required for a result of addition of the sum vectors pair, for example, double the size thereof. The accumulated vector is illustrated in FIG. 2B and denoted therein 9.

Upon termination of the internal loop, by which all taps have been processed, the accumulated vector may be truncated to a length compatible with that of the signal portions being processed during each external loop iteration. For example, as shown in FIG. 2A, a result vector of 16 elements may be obtained using a saturation operation on the accumulated vector originally comprising 32 elements. The result vector is illustrated in FIG. 2B and denoted therein as 10.

Next, elements of the filtered signal, as comprised in the result vector obtained, may be stored in a storage unit configured for accommodating an elements series of a respective length, for example, as shown in FIG. 2A, a length of 512 bits total. The respective output portion comprising the filtered signal elements is denoted in FIG. 2B as 11.

Referring now to FIG. 3, which is a schematic illustration of an exemplary processing instruction for obtaining a dual right-shift vectors pair, in accordance with some embodiments of the present invention.

An exemplary instruction for obtaining a pair of dual right-shift vectors, such as the exemplary ESHFTR.OFF.STP.CPX.V instruction employed by the exemplary code in Fig. 2A for obtaining first and second dual right-shift vectors 7a, 7b as illustrated in Fig. 2B, may be implemented in a manner as illustrated in Fig. 3.

As shown in Fig. 3, the ESHFTR.OFF.STP.CPX.V instruction may be configured to receive the following arguments: Va, Vb, Vm, Vn, and imm3. The arguments Va and Vb may be references or pointers to storage units for accommodating the two output vectors, i.e. the dual right-shift vectors pair. Similarly, the arguments Vm and Vn may be likewise indications of storage units accommodating the two input vectors from which the output vectors may be obtained. The first input vector, referred to as Vm, may be a vector on which right-shift operations may be performed by the instruction, while the second input vector, referred to as Vn, may be a vector from which replacement elements may be retrieved and placed by the instruction into vector Vm following right-shifting thereof, in substitution of elements originally comprised therein. The argument imm3 may be an offset parameter, indicating an offset to a leftwards direction with respect to an element of the second input vector Vn at which a current pointer being located and pointing towards.

Specifically, if an element being pointed to is the right-most element, then by setting imm3 to {0, 1, 2, ...} and so forth for any likewise positive integer values below a total length of Vn, any one of the elements of Vn may readily be referenced. For this reason, it may be useful to have the current pointer located at the right end of Vn rather than at its left end. This may be achieved by employing a suitable load instruction, such as the exemplary instruction LD.V128.UA.BCK.CP used for loading the fourth sub-vector as illustrated in Fig. 2A.

For illustrative purposes, input vector Vm is portrayed in Fig. 3 as having 16 elements in total, denoted as [0, 1, 2 ... 15] from right to left. It is to be understood, however, that the present invention is not limited in such manner, and other vector sizes may be applicable as well. Similarly, for illustrative purposes, input vector Vn is portrayed in Fig. 3 as having at least two elements, denoted as [e1] and [e2], and additional elements located rightwards of element [e1], leftwards of element [e2], and/or between elements [e1] and [e2]. It is to be understood, however, that other scenarios wherein zero or more elements located in any one or more of those locations, may be applicable.

In some exemplary embodiments, an additional parameter, which in Fig. 3 is denoted Step, may be provided. The step parameter may be coded into the settings of the FIR filter being employed, for example, using a definition set file or data structure, as illustrated in Fig. 3 and denoted therein FIR_MODE. The step parameter may be used for indicating another offset to a leftwards direction with respect to an element of the second input vector Vn at which a current pointer may be located, which offset being equal to imm3+step.

As illustrated in Fig. 3, the ESHFTR.OFF.STP.CPX.V instruction may be configured for performing a right-shift operation on the first input vector Vm, thereby each of the elements denoted [1 ... 15] may be moved one location to the right, and the element denoted [0], formerly located at the right-most location, now may be moved to the left-most location. Then, an element of the second input vector Vn located at the specified offset imm3, denoted in Fig. 3 as [e1], may be retrieved and placed at the left-most location of Vm instead of the element denoted [0], thereby obtaining the first output vector Va which comprises elements [1 ... 15, e1], and which may then be copied and written back to the storage allocated therefor.

Next, as illustrated in Fig. 3, the exemplary ESHFTR.OFF.STP.CPX.V instruction may be configured for performing another right-shift operation on Vm, thereby elements [2 ... 15] and lastly element [e1] may all be moved one location to the right, and the element denoted [1], formerly located at the right-most location, now may be moved to the left-most location. Then, another element of Vn, located at the offset imm3+Step as obtained by the parameters imm3 and Step specified, which element being denoted in Fig. 3 as [e2], may be retrieved and placed at the left-most location of Vm instead of the element denoted [1], thereby obtaining the second output vector Vb which comprises elements [2 ... 15, e1, e2] and which may then be copied and written back to the storage allocated therefor.

It will be appreciated that an instruction for obtaining a dual left-shift vectors pair, such as the exemplary ESHFTL.OFF.STP.CPX.V instruction employed in the exemplary code of Fig. 2A for obtaining first and second dual left-shift vectors 6a, 6b as illustrated in Fig. 2B, may be implemented in a similar manner, using left-shift operations instead of right-shift operations, and treating the offset parameters, imm3 and Step, as indicating an offset and/or step in a rightwards direction with respect to an element currently being pointed to, instead of in a leftwards direction.

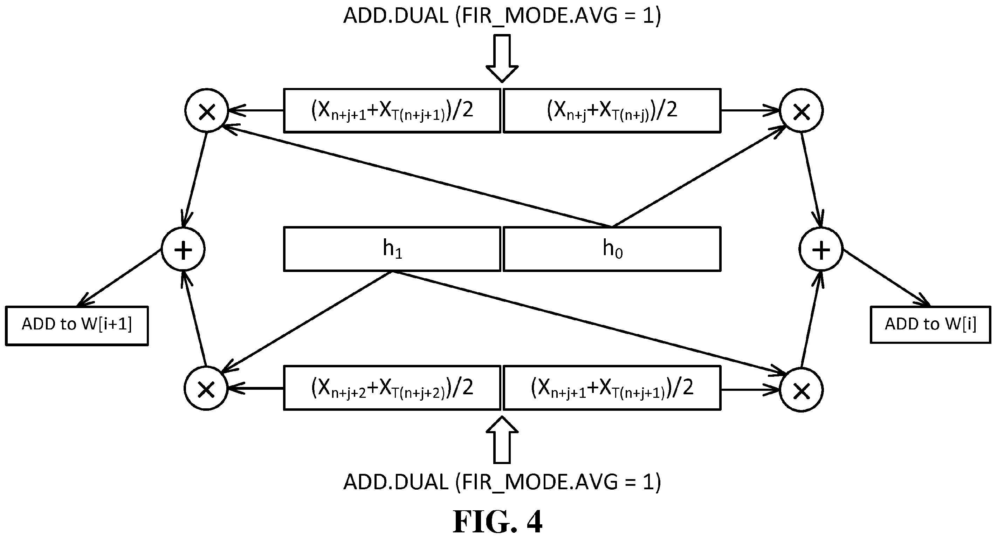

Reference is now made to FIG. 4, which is a schematic illustration of an exemplary processing instruction for dual addition of two vectors pairs and usage thereof in multiplication by two FIR filter coefficients, in accordance with some embodiments of the present invention.

An exemplary instruction for dual addition of two pairs of vectors, such as the exemplary ADD.DUAL.CPX.SAT.V instruction employed in the exemplary code of Fig. 2A for obtaining first and second sum vectors 8a, 8b as illustrated in Fig. 2B, may be configured to receive the following arguments: Vg:Vh, Vk, Vz, Vi, and Vy. Each of these arguments may be a pointer to a storage unit for accommodating a vector of a predetermined size, for example, 16 complex data elements in 16-bit representation. For the sake of convenience, all arguments may be assumed herein as referring to vector registers.

The ADD.DUAL.CPX.SAT.V instruction may be configured to perform two additions, e.g. two 16 way 16-bit signed complex additions, as in the example at hand. The first addition may add vector register Vk to vector register Vi, and may then write the 16 way 16-bit signed complex results to vector register Vg. Similarly, the second addition may add vector register Vz to vector register Vy, and may then write the 16 way 16-bit signed complex results to vector register Vh.

In some exemplary embodiments, the addition operation type may be controlled by a parameter, denoted herein as Avg. The parameter Avg may be coded in the settings of the FIR filter being employed, as shown in Fig. 4 and denoted therein as FIR_MODE.Avg, respectively. The parameter Avg may be a 1-bit flag that may be either set to 1 or cleared to 0. In case that Avg is cleared to 0, the addition results may be signed saturated to 16-bit. In case that Avg is set to 1, the addition results may be right-shifted by one, which may effectively yield results equivalent to an average of the two vectors summed, i.e. an addition followed by a division by 2. The latter option may be useful, for example, in dealing with filters of an odd length or the like, wherein a same coefficient may be multiplied by a same vector of signal elements twice, as may be the case for a single coefficient in a center of such filter.

As shown in Fig. 4, an exemplary ADD.DUAL.CPX.SAT.V instruction, also referred to herein as ADD.DUAL in short, may receive as inputs four vectors, denoted herein as $X_{n+j}$, $X_{T(n+j)}$, $X_{n+j+1}$, and $X_{T(n+j+1)}$, and perform two additions, which may then be followed each by a right-shift operation, due to the parameter FIR_MODE.Avg being set 1. The first of the two additions may add together the vectors $X_{n+j}$ and $X_{T(n+j)}$, and the second one may add together the vectors $X_{n+j+1}$ and $X_{T(n+j+1)}$, which may result, after the right-shift operation, in two output vectors of averaged results, denoted as $X_{n+j}+X_{T(n+j)}/2$ and $X_{n+j+1}+X_{T(n+j+1)}/2$ respectively.

In some exemplary embodiments, the function T(k) may be adapted for matching elements of vectors $X_k$ and $X_{T(k)}$ such that a sum thereof may be multiplied by a same FIR filter coefficient, for example, X[n:n+15] and X[n+N:n+N+15], in case of a symmetric FIR filter of order N being applied to subsequent signal segments each of which comprising 16 elements in total, as described herein.

As shown in Fig. 4, the first averages vector $X_{n+j}+X_{T(n+j)}/2$ may be multiplied by a multiplier $h_0$ from the FIR filter, and the second averages vector $X_{n+j+1}+X_{T(n+j+1)}/2$ may be multiplied by another multiplier $h_1$ from the FIR filter. The multiplication results may be added together, and the addition result may then be added to a wide vector W[i] in which results of the i-th iteration may be retained and/or accumulated. Similarly, at a following iteration, the ADD.DUAL instruction may receive as inputs the subsequent four vectors $X_{n+j+1}$, and $X_{T(n+j+1)}$, $X_{n+j+2}$, and $X_{T(n+j+2)}$, and perform two additions followed by right-shift operations for obtaining the two averages vectors $X_{n+j+1}+X_{T(n+j+1)}/2$ and $X_{n+j+2}+X_{T(n+j+2)}/2$, which may then be multiplied by $h_0$ and $h_1$ respectively. The multiplication results may be added to a respective wide vector W[i+1] wherein results of the (i+1)-th iteration may be aggregated and saved.

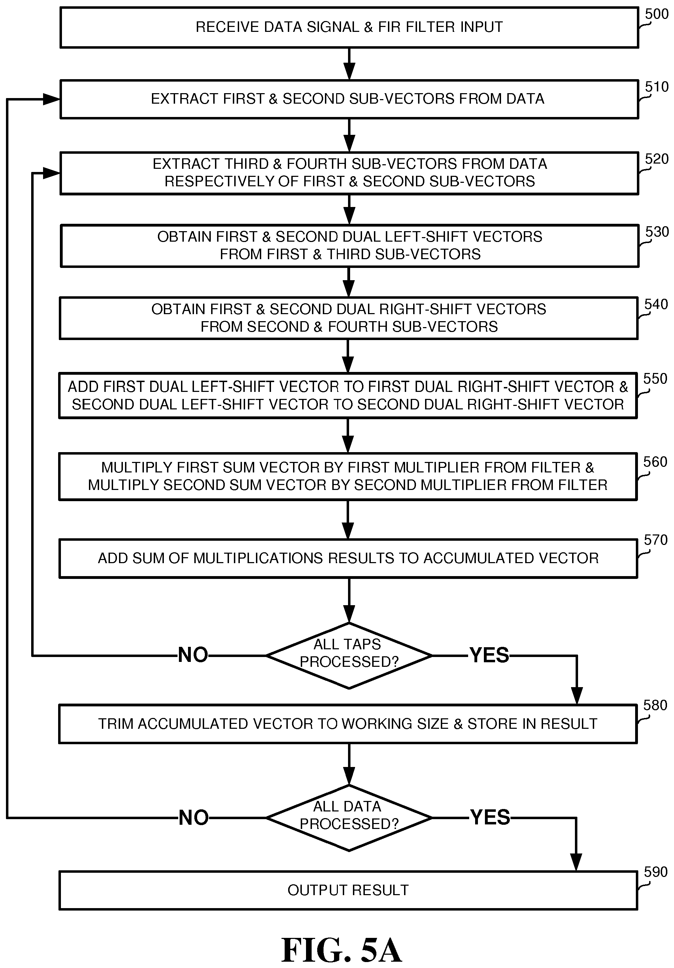

Reference is now made to FIG. 5A, which is a flowchart of a method of signal processing by symmetric FIR filtering, in accordance with some embodiments of the present invention.

At Step 500, an input comprising a plurality of elements representing sequential values of a data signal and a FIR filter may be received. The FIR filter may be a symmetric filter. The signal and/or the FIR filter may comprise any arbitrary number of elements. The elements of the signal may be real numbers, complex numbers, and/or the like. Similarly, the FIR filter may comprise real coefficients and/or the like.

At Step 510, first and second sub-vectors may be extracted from the data signal. Each of the first and second sub-vectors may comprise a segment of the signal at a predetermined length, for example, 16 elements long, such as sub-vectors 1 and 2 as illustrated in Figs. 2A and 2B.

In some exemplary embodiments, the first and second sub-vectors may be segments of the signal, situated N elements apart from one another, wherein N being the order of the FIR filter, i.e. the filter comprising N+1 coefficients in total. In some further exemplary embodiments, a pre-processing step comprising right-shifting the first sub-vector by one element and left-shifting the second sub-vector by one element may be performed, so that the sub-vectors may be correctly predisposed for the remainder of execution flow. For example, the first and second sub-vectors may initially comprise the signal elements at locations [0 ... 15] and [N ... N+15] respectively, whereas following the pre-processing step, the first and second sub-vectors may be of the form [15, 0, 1 ... 14] and [N+1, N+2, ... N+15, N] respectively.

At Step 520, third and fourth sub-vectors may be extracted from the data signal, respective of the first and second sub-vectors. The third sub-vector may comprise a segment of the signal immediately succeeding the first sub-vector, and the fourth sub-vector may comprise a segment of the signal immediately preceding the second sub-vector, each of which segments having a predetermined length, for example, 4 elements long, similarly as sub-vectors 3 and 4 as illustrated in Figs. 2A and 2B.

To illustrate, in case that the first and second sub-vector initially comprise the signal elements at locations [15, 0, 1 ... 14] and [N+1, N+2, ... N+15, N] respectively, as in the running example, then the third sub-vector may comprise the signal elements at locations [15, 16, 17, 18] and the fourth sub-vector may comprise the signal elements at locations [N-3, N-2, N-1, N] accordingly.

At Step 530, first and second dual left-shift vectors may be obtained from the first and third sub-vectors. The dual left-shift vectors pair may be obtained using a left-shift instruction, by which the first sub-vector may be left-shifted by one and two elements and its right-most elements may be replaced by elements retrieved from the third sub-vector, similarly as described herein and illustrated in Figs. 2A and 2B with respect to first and second dual left-shift vectors 6a and 6b.

In some exemplary embodiments, an offset parameter and a step parameter may be provided, such that a first element retrieved from the third sub-vector may be located at the specified offset from a left-most element therein, and a second element retrieved therefrom may be located at the specified step from the first element retrieved. For example, if the offset parameter is set to 0 and the step parameter is set to 1, the elements retrieved may be the two left-most elements in the third sub-vector. Similarly, if the offset parameter is set to 1 and the step parameter is set to 2, the elements retrieved may be the second and fourth elements from the left.

To illustrate, in the running example where the first and third sub-vector comprise the signal elements at locations [15, 0, 1 ... 14] and [15, 16, 17, 18] respectively, then using an offset 0 and step 1, the dual left-shift vectors pair obtained may comprise the elements at locations [0, 1, ... 15] and [1, 2, ... 16] respectively.

At Step 540, first and second dual right-shift vectors may be obtained from the second and fourth sub-vectors. The dual right-shift vectors pair may be obtained using a right-shift instruction, by which the second sub-vector may be right-shifted by one and two elements and its left-most elements may be replaced by elements retrieved from the fourth sub-vector, similarly as described herein and illustrated in Figs. 2A and 2B with respect to first and second dual right-shift vectors 7a and 7b, and further in detail in Fig. 3.

In some exemplary embodiments, as illustrated in Fig. 3, an offset parameter and a step parameter may be provided, such that a first element retrieved from the fourth sub-vector may be located at the specified offset from a right-most element therein, and a second element retrieved therefrom may be located at the specified step from the first element retrieved. For example, if the offset parameter is set to 0 and the step parameter is set to 1, the elements retrieved may be the two right-most elements in the fourth sub-vector. Similarly, if the offset parameter is set to 1 and the step parameter is set to 2, the elements retrieved may be the second and fourth elements from the right.

To illustrate, in the running example where the second and fourth sub-vector comprise the elements at locations [N+1, N+2, ... N+15, N] and [N-3, N-2, N-1, N] respectively, then using an offset 0 and step 1, the dual left-shift vectors pair obtained may comprise the elements at locations [N, N+1, N+2, ... N+15] and [N-1, N, ... N+14] respectively.

At Step 550, the first dual left-shift vector, as obtained at Step 530, may be added to the first dual right-shift vector, as obtained at Step 540, and the second dual left-shift vector, as obtained at Step 530, may be added to the second dual right-shift vector, as obtained at Step 540. The addition of the two pairs of vectors may be performed using a dual addition instruction, similarly as described herein and illustrated in Figs. 2A and 2B with respect to first and second sum vectors 8a and 8b, and further in detail in Fig. 4.

At Step 560, the first sum vector as obtained by the dual addition operation performed at Step 550, may be multiplied by a first multiplier from the FIR filter received as input at Step 500, and the second sum vector as obtained by the dual addition operation performed at Step 550, may be multiplied by a second multiplier from the FIR filter.

At Step 570, a sum of the multiplication results obtained at Step 560 may be added to an accumulated vector, in which a sum of results obtained in previous iterations may be retained, similarly as described herein and illustrated in Figs. 2A and 2B with respect to accumulated vector 9 and further in Fig. 4. The accumulated vector may be a wide vector of a size capable of accommodating addition results of vectors of a size as the multiplication outcomes of the first and second sum vectors by the two FIR filter multipliers. For example, in case of the first and second sum vectors comprising each 16 elements, then the accumulated vector may be a vector of 32 elements.

In case that all taps have been processed at this point, namely all coefficients of the FIR filter have been multiplied by a respective signal component, then the method may proceed to Step 580. Otherwise, if there are taps to be processed remaining, the method may return back to Step 520 and continue for additional one or more iterations.

It will be appreciated that in each further iteration, the third and fourth sub-vectors obtained at Step 520 may be in correspondence to a current composition of the first and second sub-vectors, as resulting from respective shift left and shift right instructions executed thereon in previous iterations.

To illustrate, with respect to the running example, wherein during and upon completion of a first iteration, following the shift left instruction performed at Step 530, the first sub-vector comprises signal elements at locations [1, 2, ... 16], and following the right shift instruction performed at Step 540, the second sub-vector comprises signal elements at locations [N-1, N, ... N+14], then at a following iteration continuing to processing of the next remaining taps, the third and fourth sub-vectors may comprise signal elements at locations [17, 18, 19, 20] and [N-5, N-4, N-3, N-2] respectively.

At Step 580, after all taps have been processed, the accumulated vector retaining calculation results obtained and summed up together during previous iterations, may be trimmed to a working size employed for iteratively and sequentially computing the filtered signal in segments of a predetermined length, and the remaining elements may be stored in a result vector. For example, in case of the first and second sub-vectors as processed throughout Steps 510 to 540 comprise 16 elements each, such that the accumulated vector comprises 32 elements in total, then at Step 580 the accumulated vector may be trimmed to 16 elements, and these 16 elements may then be stored in the result vector, representing a respective segment of the filtered signal at this length.

In case that all elements of the data signal received as input at Step 500 have been processed, the method may proceed to Step 590. Otherwise, the method may return back to Step 510 and subsequent segments of the signal data for filtering by the FIR filter may be processed, by iteratively repeating Steps 520 to 580 for each respective pair of first and second sub-vectors extracted from the signal.

For example, in case of employing a working size of 16 elements of the data signal in each iteration, then the first and second sub-vectors extracted at Step 510 may comprise elements at locations [n:n+15] and [n+N:n+N+15], respectively, during a first of two subsequent iterations, and at locations [n+16:n+30] and [n+N:n+N+15], respectively, during the second iteration of the two, wherein n may take integer values at zero and/or above.

At Step 590, after all elements of the data signal have been processed, the filtered signal obtained as result may be outputted.

For illustrative purposes, exemplary calculation of first 16 elements of a filtered signal Y[n] output, obtained from a signal X[n] and a symmetric FIR filter h[n] of order N input, is provided in Table 1 herein. The cells of Table 1 comprise terms being sums of elements of X[n] to be multiplied by respective taps of h[n], each represented by a different row. The columns of Table 1 correspond to elements of Y[n], obtained as a sum of the multiplications of the terms in all rows by the respective taps.

| Table 1 | | | | | |
|---|---|---|---|---|---|
| | Y[0] | Y[1] | Y[2] | | Y[15] |
| h[0] | X[0]+X[N] | X[1]+X[N+1] | X[2]+X[N+2] | | X[15]+X[N+15] |
| h[1] | X[1]+X[N-1] | X[2]+X[N] | X[3]+X[N+1] | | X[16]+X[N+14] |
| h[2] | X[2]+X[N-2] | X[3]+X[N-1] | X[4]+X[N] | . | X[17]+X[N+13] |
| h[3] | X[3]+X[N-3] | X[4]+X[N-2] | X[5]+X[N-1] | . | X[18]+X[N+12] |
| ... | | | | . | |
| h [(N-1)/2] | X[(N-1)/2]+ X [(N-1)/2+1] | X[(N-1)/2+1]+ X [(N-1)/2+2] | X[(N-1)/2+2]+ X [(N-1)/2+3] | | X[(N-1)/2+15]+ X [(N-1)/2+16] |

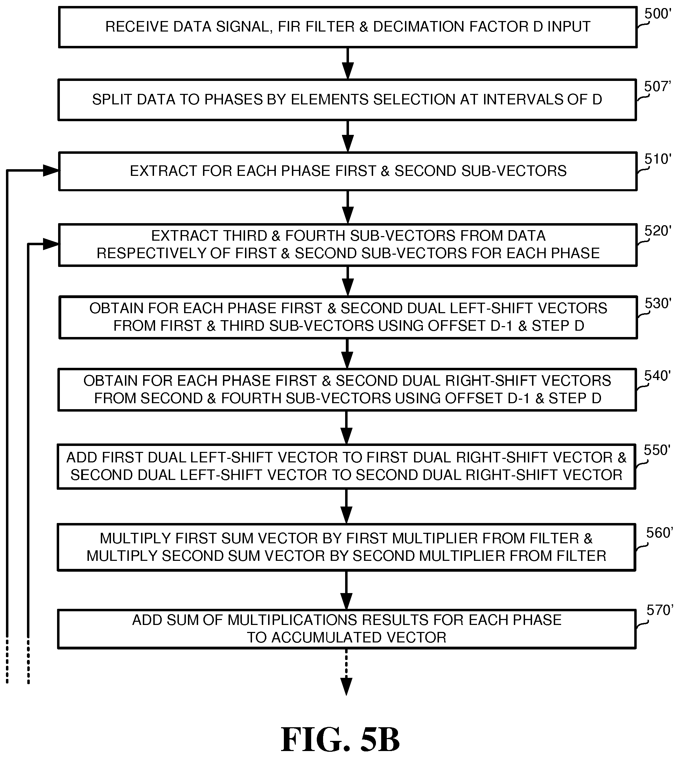

Reference is now made to FIG. 5B, which is a flowchart of a method of signal processing by symmetric FIR filtering and decimation, in accordance with some embodiments of the present invention.

At Step 500', an input comprising a plurality of elements representing sequential values of a data signal and a FIR filter may be received, similarly as in Step 500 of Fig. 5A. Additionally, the input may further comprise a decimation factor D. The decimation factor D may be an integer number, equal to or greater than 2.

A decimation operation in the context of signal processing is aimed at rate reduction of a signal. Decimation by an integer factor M may be implemented by applying a low-pass filter for reducing high-frequency signal components and keeping only every M-th sample. For decimation with FIR filtering, the decimated signal output may be calculated using the formula (3) as follows:

$$(3) \qquad y[n] = \sum_{k=0}^{K-1} x[nM - k] \cdot h[k]$$

where the h[k] sequence being the impulse response, i.e. the filter coefficients, and K is its length, i.e. the order of the filter.

For example, decimation by factor 2 using a symmetric FIR filter of order N may be calculated using the formula (4) as follows:

$$(4) \qquad y[n] = (x[2n] + x[2n - N]) \cdot h[0] + $$
$$(x[2n - 1] + x[2n - (N - 1)]) \cdot h[1] + \cdots$$

It will be appreciated that impulse response coefficients taken at intervals of M form a subsequence of filter elements, and that there are M such subsequences multiplexed together, also commonly referred to as phases.

Referring back to Fig. 5B, at Step 507', the data signal received at Step 500' as input may be split into D subsequences (phases) by selection of signal elements at intervals of D, wherein each phase starting at one of the locations {0, 1, ... D-1}.

For example, in case of factor 2 decimation, the data may be split into 2 phases, one of which comprising all elements at even locations, i.e. [0, 2, 4, ...] and another comprising all elements at odd locations [1, 3, 5, ...]. Similarly, in case of decimation by factor 3, the data may be split into 3 phases, the first of which comprising elements at locations [0, 3, 6, ...], the second comprising elements at locations [1, 4, 7, ...], and the third comprising elements at locations [2, 5, 8, ...]. Generally speaking, for each j in {0, 1, ... D-1}, respective phase j may comprise elements at all locations n for which j = n modulo D.

At Step 510', for each of the D phases into which the signal has been split at Step 507', first and second sub-vectors may be extracted. For example, in case of decimation by factor 2 and a FIR filter of order N, and assuming that a working size of segments used for processing the signal being of 16 data elements each, then for a first phase comprising elements at even locations (the "even phase"), the first sub-vector extracted in a first iteration may comprise signal elements at locations [0, 2, 4, ... 30], and the second sub-vector may comprise elements at locations [N, N+2, ... N+30]. Similarly, for a second phase comprising elements at odd locations (the "odd phase"), the first and second sub-vectors extracted in a first iteration may comprise signal elements at locations [1, 3, 5, ... 31] and [N+1, N+3, ... N+31] respectively.

At Step 520', for each of the D phases, third and fourth sub-vectors may be extracted from the data signal, respective of the first and second sub-vectors extracted at Step 510', similarly as in Step 520 of Fig. 5A. The third sub-vector may comprise signal elements succeeding a last element of the first sub-vector, for example, if the first sub-vector comprises elements at locations [0, 2, 4, ... 30] then the third sub-vector may comprise elements at locations [31, 32, 33, 34]. The fourth sub-vector may comprise signal elements preceding a first element of the second sub-vector, for example, if the second sub-vector comprises elements at locations [N, N+2, ... N+30] then the fourth sub-vector may comprise elements at locations [N-4, N-3, N-2, N-1].

At Step 530', for each of the D phases, first and second dual left-shift vectors may be obtained from the first and third sub-vectors as extracted at Steps 510' and 520'. The first and second dual left-shift vectors may be obtained using a shift left instruction with an offset parameter of D-1 and a step parameter of D, respective of the decimation factor D received at Step 500'. Accordingly, the first dual left-shift vector may be obtained by left-shifting the first sub-vector once and replacing a right-most element thereof by an element of the third sub-vector at an offset D-1 from its left end, and the second dual left-shift vector may be obtained by left-shifting the first sub-vector again and replacing a right-most element thereof by an element of the third sub-vector at a step D from the element retrieved first.

For example, in case of decimation by factor 2, and assuming that for the even phase, the first and third sub-vectors comprise elements at locations [0, 2, 4, ... 30] and [31, 32, 33, 34] respectively, then the first element retrieved from the third sub-vector may be at an offset 1 from left, and the second element retrieved therefrom may be at an offset 1+2=3 from left, resulting at first and second dual left-shift vectors comprising elements at locations [2, 4, 6, ... 30, 32] and [4, 6, ... 30, 32, 34] respectively.

At Step 540', for each of the D phases, first and second dual right-shift vectors may be obtained from the second and fourth sub-vectors as extracted at Steps 510' and 520'. The first and second dual right-shift vectors may be obtained using a shift right instruction with an offset parameter of D-1 and a step parameter of D, respective of the decimation factor D received at Step 500'. Accordingly, the first dual right-shift vector may be obtained by right-shifting the second sub-vector once and replacing a left-most element thereof by an element of the fourth sub-vector at an offset D-1 from its right end, and the second dual right-shift vector may be obtained by right-shifting the second sub-vector again and replacing a left-most element thereof by an element of the fourth sub-vector at a step D from the element retrieved first.

For example, in case of decimation by factor 2, and assuming that for the even phase, the second and fourth sub-vectors comprise elements at locations [N, N+2, ... N+30] and [N-4, N-3, N-2, N-1] respectively, then the first element retrieved from the fourth sub-vector may be at an offset 1 from right, and the second element retrieved therefrom may be at an offset 1+2=3 from right, resulting at first and second dual right-shift vectors comprising elements at locations [N-2, N, N+2, ... N+28] and [N-4, N-2, N, ... N+26] respectively.

At Step 550', for each of the D phases, the first dual left-shift vector as obtained at Step 530' may be added to the first dual right-shift vector as obtained at Step 540', and the second dual left-shift vector as obtained at Step 530' may be added to the second dual right-shift vector as obtained at Step 540', similarly as in Step 550 of Fig. 5A.

At Step 560', for each of the D phases, the first sum vector as obtained by the dual addition operation performed at Step 550', may be multiplied by a first multiplier from the FIR filter received as input at Step 500', and the second sum vector as obtained by the dual addition operation performed at Step 550', may be multiplied by a second multiplier from the FIR filter. The first and second multipliers may be retrieved from the FIR filter in accordance with the phase to which the multiplied first and second sum vectors correspond.

For example, in case of decimation by factor 2, the first and second multipliers for the even phase may be two adjacent coefficients at even locations of the FIR filter, e.g. h[0] and h[2], as in case of performing a first iteration of the inner loop for processing all taps. Similarly, the first and second multipliers for the odd phase may be two adjacent coefficients at odd locations of the filter, e.g. h[1] and h[3], as in such case of the first iteration.

At Step 570', a sum of the multiplication results as obtained at Step 560' for each of the D phases, may be added to an accumulated vector in which results obtained in previous iterations being retained, similarly as in Step 570 of Fig. 5A. The method may then proceed similarly as in Step 580 of Fig. 5A, in case that all taps have been processed, or return to Step 520' otherwise. After proceeding similarly as in Step 580 of Fig. 5A, the method may further proceed in a similar manner to Step 590 of Fig. 5A, in case that all elements of the data signal have been processed, or return to Step 510' otherwise.

For illustrative purposes, exemplary calculation of first 16 elements of a decimated signal Y[n] output by an integer decimation factor D, which decimated signal being obtained from a signal X[n] and a symmetric FIR filter h[n] of order N received as input, is provided in Table 2 herein. Similarly as in Table 1, each row corresponds to a tap from h[n] and each column corresponds to an element of Y[n]. The cells are occupied by sums of respective terms of X[n] to be multiplied by the respective tap of the row and added together for obtaining the respective element Y[n] of the column.

| Table 2 | | | | |
|---|---|---|---|---|
| | Y[0] | Y[1] | Y[2] | Y[15] |
| h[0] | X[0]+X[N] | X[D]+X[N+D] | X[2D]+ X[N+2D] | X[15]+ X[N+15D] |

(continued)

| | Y[0] | Y[1] | Y[2] | | Y[15] |
|---|---|---|---|---|---|
| | | | | | |
| h[1] | X[1]+X[N-1] | X[D+1]+ X[N-1+D] | X[2D+1]+ X[N-1+2D] | . | X[16]+ X[N-1+15D] |
| | | | | . | |
| h[2] | X[2]+X[N-2] | X[D+2]+ X[N-2+D] | X[2D+2]+ X[N-2+2D] | . | X[17]+ X[N-2+15D] |
| h[3] | X[3]+X[N-3] | X[D+3]+ X[N-3+D] | X[2D+3]+ X[N-3+2D] | | X[18]+ X[N-3+15D] |
| ... | | | | | |

**Table 2**

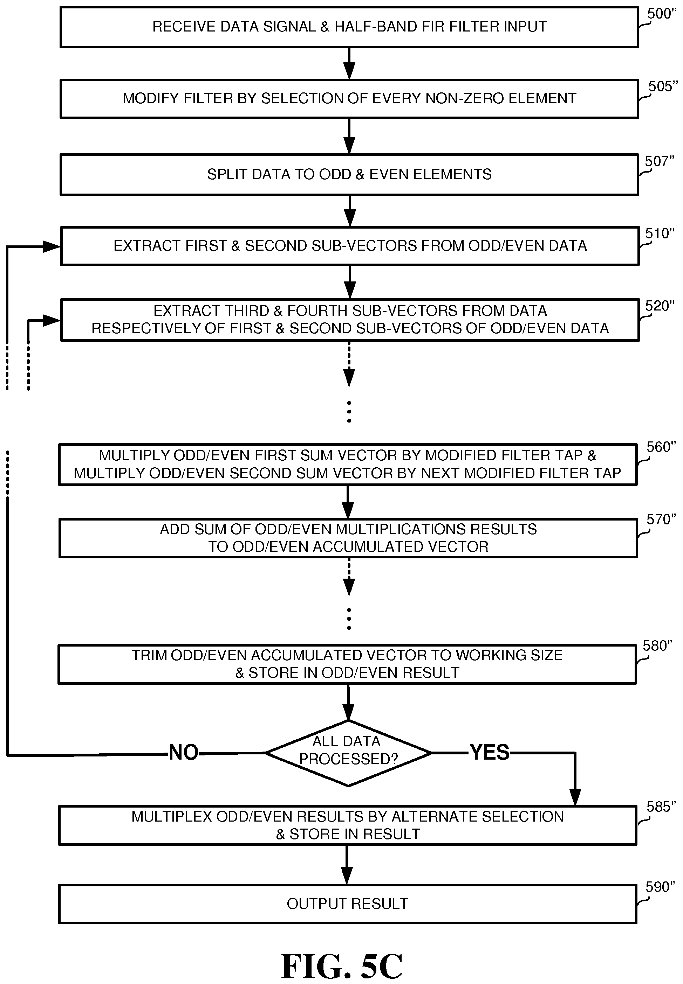

Reference is now made to FIG. 5C, which is a flowchart of a method of signal processing by half-band symmetric FIR filtering, in accordance with some embodiments of the present invention.

At Step 500", an input comprising a plurality of elements representing sequential values of a data signal and a FIR filter may be received, similarly as in Step 500 of Fig. 5A, or Step 500' of Fig. 5B. The filter received as input at Step 500" may be a half-band FIR filter, wherein every other coefficient thereof is zero, and non-zero elements thereof being symmetric around its center.

At Step 505", the half-band FIR filter received as input at Step 500" may be modified by selection of every non-zero element thereof, so as to obtained a shorter filter which is also a symmetric FIR filter. The modified filter may be treated at each of the subsequent method steps as if it had been originally received as input.

At Step 507", the data signal received as input at Step 500" may be split into two subsequences, one comprising elements at even locations, e.g. [0, 2, 4, ...], and another comprising elements at odd locations, e.g. [1, 3, 5, ...], similarly as performed at Step 507' of Fig. 5B for the different phases.

At Step 510", for each of the odd and even data subsequences as obtained at Step 507", first and second sub-vectors may be extracted therefrom, similarly as in Step 510 of Fig. 5A or Step 510' of Fig. 5B.

At Step 520", third and second sub-vectors may be extracted from the data signal, respectively of the first and second sub-vectors extracted for each of the odd and even data subsequences at Step 510". The third sub-vector may comprise elements succeeding a last element of the first sub-vector, and the fourth sub-vector may comprise elements preceding a first element of the second sub-vector.

For example, in case that for the even data series, the first and second sub-vectors each comprise 16 elements, at locations [0, 2, ... 30] and [N, N+2, ... N+30] respectively, then the third and fourth sub-vectors extracted therefor may comprise elements at locations [31, 32, 33, 34] and [N-4, N-3, N-2, N-1] respectively. Similarly, in case that for the odd data series, the first and second sub-vectors comprise 16 elements each, at locations [1, 3, ... 31] and [N+1, N+3, ... N+31] respectively, then the third and fourth sub-vectors extracted therefor may comprise elements at locations [32, 33, 34, 35] and [N-3, N-2, N-1, N] respectively.

The method may then proceed similarly as in Steps 530 to 550 of Fig. 5A or Steps 530' to 550' of Fig. 5B, to obtain from the first, second, third and fourth sub-vectors obtained at Steps 510" and 520" for each of the even and odd data series, first and second dual left-shift vectors, first and second dual right-shift vectors, and first and second sum vectors as resulting from dual addition of the first dual left-shift vector to the first dual right-shift vector and the second dual left-shift vector to the second dual right-shift vector. The dual left-shift vectors and dual right-shift vectors may be obtained using respective left shift and right shift instructions with an offset parameter of 1 and a step parameter of 2, similarly as in Steps 530' and 540' of Fig. 5B with respect to a decimation factor of 2.

At Step 560", two taps from the modified FIR filter obtained at Step 505" may be multiplied by the first and second sum vectors of each of the even and odd data series, i.e. the first sum vector for the even series and the first sum vector for the odd series may each be multiplied by a first tap from the modified filter, and the second sum vectors for the even and odd series respectively may each be multiplied by a second tap from the modified filter.

At Step 570", for each of the even and odd data series, a sum of the multiplication results may be added to a respective accumulated vector retaining results obtained in previous iterations, i.e. results obtained for the even series may be added to a first accumulated vector ("even" accumulated vector), and results obtained for the odd series may be added to a second accumulated vector ("odd" accumulated vector).

The method may then proceed to Step 580", in case all taps of the modified FIR filter have been processed. Otherwise, the method may return to Step 520".

At Step 580", each of the odd/even accumulated vectors may be trimmed to a working size, similarly as in Step 580 of Fig. 5A or Step 580' of Fig. 5B, and the two resulting trimmed vectors may be stored in respective odd/even result vectors.

The method may then proceed to Step 585", in case all elements of the data signal have been processed. Otherwise, the method may return to Step 510".

At Step 585", the even and odd result vectors may be multiplexed together to a single multiplex vector by alternate selection of elements, such that elements of the even result vector may occupy the even locations of the multiplex vector, and elements of the odd result vector may occupy the odd locations of the multiplex vector. The multiplex vector thus obtained may be stored in a result vector.

At Step 590", the result vector comprising the output filtered signal may be outputted, similarly as in Step 590 of Fig. 5A.

In some exemplary embodiments, half-band filtering may be accompanied by factor 2 decimation. In such case, all operations concerning odd data series and multiplexing of the results may be skipped, i.e. only the even data series may be processed.

For illustrative purposes, exemplary calculation of first 16 elements of a filtered signal Y[n] output obtained from a signal X[n], a half-band FIR filter h[n] of order N received as input and decimation by factor 2, is provided in Table 3 herein. Similarly as in Table 1 and Table 2, each row corresponds to a tap from h[n] and each column corresponds to an element of Y[n]. The cells are occupied by sums of respective terms of X[n] to be multiplied by the respective tap of the row and added together for obtaining the respective element Y[n] of the column.

| Table 3 | | | | | |
|---|---|---|---|---|---|
| | Y[0] | Y[1] | Y[2] | | Y[15] |
| h[0] | X[0]+X[N] | X[2]+X[N+2] | X[4]+X[N+4] | | X[30]+X[N+30] |
| h[2] | X[2]+X[N-2] | X[4]+X[N] | X[6]+X[N+2] | . | X[32]+X[N+28] |
| h[4] | X[4]+X[N-4] | X[6]+X[N-2] | X[8]+X[N] | . | X[34]+X[N+26] |
| h[6] | X[6]+X[N-6] | X[8]+X[N-4] | X[10]+X[N-2] | . | X[36]+X[N+24] |
| ... | | | | | |

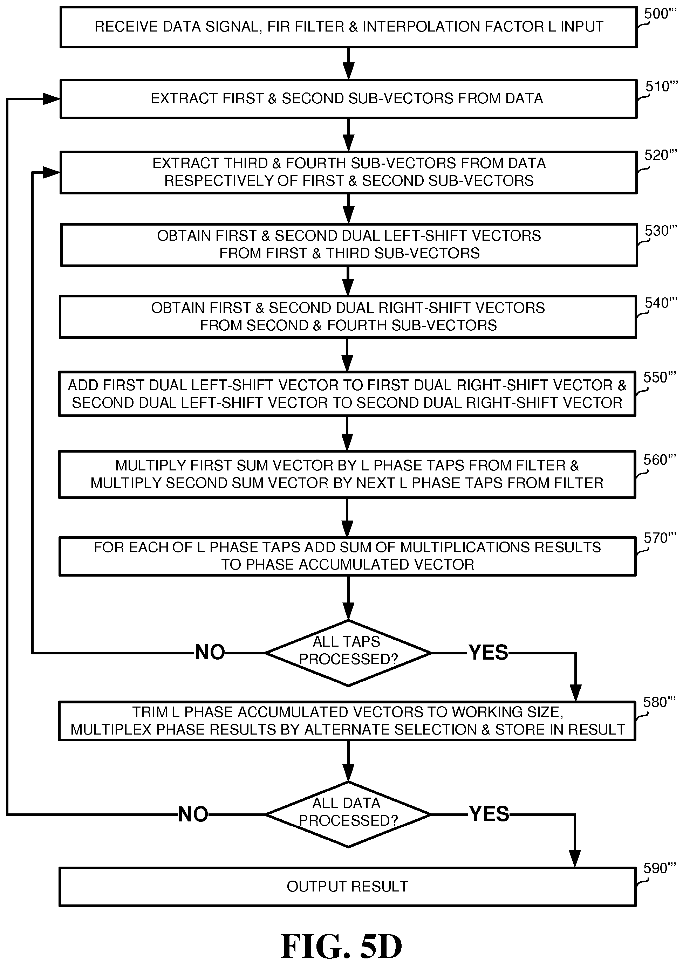

Reference is now made to FIG. 5D, which is a flowchart of a method of signal processing by symmetric FIR filtering and interpolation, in accordance with some embodiments of the present invention.

At Step 500‴, an input comprising a plurality of elements representing sequential values of a data signal and a FIR filter may be received, similarly as in Step 500 of Fig. 5A. Additionally, the input may further comprise an interpolation factor L. The interpolation factor L may be an integer number, equal to or greater than 2.

An interpolation operation in the context of signal processing is aimed at increasing the rate of the signal. Interpolation by an integer factor L may be implemented by expansion of the signal with L-1 zeros inserted between each pair of successive original samples X[n] and smoothing out discontinuities with a low-pass filter. In case of FIR filtering, the interpolated signal output may be calculated using the formula (5) as follows:

$$(5) \qquad y[j + nL] = \sum_{k=0}^{K} x[n - k] \cdot h[j + kL] , j = 0, 1, ..., L - 1$$

where the h[k] sequence being the impulse response, i.e. the filter coefficients, and K is the largest value of k for which h[j+kL] is non-zero.

It will be appreciated that impulse response coefficients taken at intervals of L form a subsequence of filter elements, and that there are L such subsequences multiplexed together, also commonly referred to as phases.

Referring back to Fig. 5D, the method steps 510‴ to 550‴ may be performed in identical manner as Steps 510 to 550 of Fig. 5A. For the sake of brevity, a detailed description thereof is thus hereby skipped.

At Step 560‴, the first sum vector as obtained at Step 550" may be multiplied by each of L phases of the FIR filter received as input at Step 500", and the second sum vector may be multiplied by each of subsequent L phases of the filter, such that 2L multiplication operations may be performed in total.

For example, in case of interpolation by factor 2, the first sum vector may be multiplied at one time by h[0] and at another time by h[1], and the second sum vector may be multiplied one time by h[2] and at another time by h[3], resulting in 4 multiplications in total.

At Step 570‴, a sum of the multiplication results obtained for each of the L phases may be added to a respective accumulated vector ("phase accumulated vector") retaining results obtained in previous iterations.

The method may then proceed to Step 580‴, in case all taps of the FIR filter have been processed. Otherwise, the method may return to Step 520‴.

At Step 580‴, each of the L phase accumulated vectors may be trimmed to a working size similarly as in Step 580 of Fig. 5A, and the results obtained for the L different phases may be multiplexed together by alternate selection of elements therefrom in a sequential manner into a single multiplex vector. For example, in case of interpolation by factor 2, results obtained for filter elements at even locations may occupy even locations of the multiplex vector, whereas results obtained for filter elements at odd locations may occupy odd locations thereof respectively.

The method may then proceed to Step 590‴, in case all elements of the data signal have been processed. Otherwise, the method may return to Step 510‴.

At Step 590‴, the interpolated signal output obtained as result of iteratively performing Steps 510‴ to 580‴, may be outputted.

For illustrative purposes, exemplary calculation of first L+1 elements of a filtered signal Y[n] output obtained from a signal X[n], a FIR filter h[n] of order N received as input and interpolation by factor L, is provided in Table 4 herein. Similarly as in Tables 1 to 3, each row corresponds to a tap from h[n] and each column corresponds to an element of Y[n]. The cells are occupied by sums of respective terms of X[n] to be multiplied by the respective tap of the row and added together for obtaining the respective element Y[n] of the column.

It will be appreciated that for a phase h[j+kL] which does not participate in a dot product by which an element Y[n] is calculated, and thus makes no contribution to the sum in the corresponding column thereof, the respective cell may therefor remain empty.

| Table 4 | | | | | |
|---|---|---|---|---|---|
| | Y[0] | Y[1] | | Y[L-1] | Y[L] |
| h[0] | X[0]+X[N] | | | | X[1]+X[N+1] |
| h[1] | | X[0]+X[N] | . | | |
| ... | | | . | | |
| h[L-1] | | | . | X[0]+X[N] | |
| h[L] | X[1]+X[N-1] | | | | X[2]+X[N] |
| ... | | | | | |

Other systems, methods, features, and advantages of the present disclosure will be or become apparent to one with skill in the art upon examination of the following drawings and detailed description.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to best explain the principles of the embodiments, the practical application or technical improvement over technologies found in the marketplace, or to enable others of ordinary skill in the art to understand the embodiments disclosed herein.

It is expected that during the life of a patent maturing from this application many relevant processors will be developed and the scope of the term processor is intended to include all such new technologies a priori.

As used herein the term "about" indicates that the value has to be intended with some approximation due to tolerances. For example the term "about" may refers to $\pm$ x %, for instance $\pm$ 10 %.

The terms "comprises", "comprising", "includes", "including", "having" and their conjugates mean "including but not limited to". This term encompasses the terms "consisting of" and "consisting essentially of".

The phrase "consisting essentially of" means that the composition or method may include additional ingredients and/or steps, but only if the additional ingredients and/or steps do not materially alter the basic and novel characteristics of the claimed composition or method.

As used herein, the singular form "a", "an" and "the" include plural references unless the context clearly dictates otherwise. For example, the term "a compound" or "at least one compound" may include a plurality of compounds, including mixtures thereof.

The word "exemplary" is used herein to mean "serving as an example, instance or illustration". Any embodiment described as "exemplary" is not necessarily to be construed as preferred or advantageous over other embodiments and/or to exclude the incorporation of features from other embodiments.

The word "optionally" is used herein to mean "is provided in some embodiments and not provided in other embodiments". Any particular embodiment of the invention may include a plurality of "optional" features unless such features conflict.

Throughout this application, various embodiments of this invention may be presented in a range format. It should be understood that the description in range format is merely for convenience and brevity and should not be construed as an inflexible limitation on the scope of the invention. Accordingly, the description of a range should be considered to have specifically disclosed all the possible subranges as well as individual numerical values within that range. For example, description of a range such as from 1 to 6 should be considered to have specifically disclosed subranges such as from 1 to 3, from 1 to 4, from 1 to 5, from 2 to 4, from 2 to 6, from 3 to 6 etc., as well as individual numbers within that range, for example, 1, 2, 3, 4, 5, and 6. This applies regardless of the breadth of the range.

Whenever a numerical range is indicated herein, it is meant to include any cited numeral (fractional or integral) within the indicated range. The phrases "ranging/ranges between" a first indicate number and a second indicate number and "ranging/ranges from" a first indicate number "to" a second indicate number are used herein interchangeably and are meant to include the first and second indicated numbers and all the fractional and integral numerals therebetween.

Certain features described in the context of various embodiments are not to be considered essential features of those embodiments, unless the embodiment is inoperative without those elements.

## Claims

1. A system for applying a Finite Impulse Response (FIR) filter, comprising:
a processing circuitry adapted to execute a code for:

receiving (500) a plurality of elements representing sequential values of a signal and a FIR filter;
calculating from the plurality of elements filtered data by performing the following in each of a plurality of iterations:

extracting (510, 520) from the plurality of elements first and second sub-vectors, a third sub-vector that succeeds the first sub-vector, and a fourth sub-vector that precedes the second sub-vector, wherein the first and second sub-vectors respectively comprise consecutive values of the signal, the second sub-vector comprises a sequence of elements starting at a location TAP_LEN+1 elements away further ahead of a first element of the first sub-vector, and TAP_LEN+1 denotes a total length of the FIR filter;
shifting (530) left the first sub-vector by at least one element and replacing elements at right-most locations thereof by elements of the third sub-vector to obtain first and second dual left-shift vectors, wherein the first and second dual left-shift vectors are obtained by shifting left the first sub-vector by one and two elements, respectively, and replacing one or two elements, respectively, at right-most locations thereof by elements of the third sub-vector;
shifting (540) right the second sub-vector by at least one element and replacing elements at left-most locations thereof by elements of the fourth sub-vector to obtain first and second dual right-shift vectors, wherein the first and second dual right-shift vectors are obtained by shifting right the first sub-vector by one and two elements, respectively, and replacing one or two elements, respectively, at left-most locations thereof by elements of the fourth sub-vector; and
adding (550) to an accumulated vector comprising portions of the filtered data from previous iterations a sum of vectors pair obtained as an outcome of:

multiplying (560) a sum of the first dual left-shift vector and the first dual right-shift vector with a multiplier from the FIR filter; and
multiplying (570) a sum of the second dual left-shift vector and the second dual right-shift vector with another multiplier from the FIR filter.

2. The system according to claim 1, wherein the first and second dual left-shift vectors comprising elements of the first sub-vector as obtained responsive to being left-shifted once and twice respectively, wherein the first and second dual right-shift vectors comprising elements of the second sub-vector as obtained responsive to being right-shifted once and twice respectively.

3. The system according to any of the previous claims, wherein the FIR filter is symmetric and having a first length, wherein the first sub-vector and the second sub-vector are obtained at an interval of the first length, wherein a number of iterations in which the third sub-vector and the fourth sub-vector are obtained is determined as a function of the first length.

4. The system according to any of the previous claims, wherein the first sub-vector and the second sub-vector are each having a second length, wherein a number of iterations in which the first sub-vector and the second sub-vector are obtained is determined as a function of a ratio between a length of the signal and the second length.

5. The system according to any of the previous claims, wherein the first and second dual left-shift vectors are obtained by retrieving a first element of the third sub-vector at a rightward offset per a first left-shift parameter specified, and a second element of the third sub-vector at a rightward offset per a second left-shift parameter specified.

6. The system according to any of the previous claims, wherein the first and second dual right-shift vectors are obtained by retrieving a first element of the fourth sub-vector at a leftward offset per a first right-shift parameter specified, and a second element of the fourth sub-vector at a leftward offset per a second right-shift parameter specified.

7. The system according to any of the previous claims, wherein two multipliers from the FIR filter are obtained at a j-th iteration by retrieving elements at (2j-1)-th and (2j)-th locations thereof.

8. The system according to any of the previous claims, wherein the FIR filter is a half-band filter, wherein the processing circuitry being further adapted to execute a code for:

obtaining a first subsequence of the signal comprising elements at even locations thereof;
obtaining a second subsequence of the signal comprising elements at odd locations thereof;
modifying the FIR filter by selection of every non-zero elements thereof;
applying the modified filter on each of the first and second subsequences to obtain even and odd filtered data; and
multiplexing the even and odd filtered data by alternate selection of elements therefrom.

9. The system according to any of the previous claims, wherein the processing circuitry being further adapted to execute a code for:

receiving an additional input of a decimation factor D;
obtaining D subsequences of the signal each comprising elements thereof at intervals of D, each of the D subsequences starting at different element selected from the first D elements of the signal; and
for each of the D subsequences, performing in each of a plurality of iterations said extracting first, second, third and fourth sub-vectors, said left shifting and replacing elements of the first sub-vector by elements of the third sub-vector for obtaining first and second dual left-shift vectors, said right shifting and replacing elements of the second sub-vector by elements of the fourth sub-vector for obtaining first and second dual right-shift vectors, and further performing the steps of:

obtaining from each of D phases of the FIR filter first and second multipliers, multiplying a first sum vector obtained from adding the first dual left-shift vector to the first dual right-shift vector by the first multiplier, and multiplying a second sum vector obtained from adding the second dual left-shift vector to the second dual right-shift vector by the second multiplier; and
adding to the accumulated vector comprising portions of the filtered data a sum of the multiplication results obtained for each of the D phases.

10. The system according to any of the previous claims, wherein the processing circuitry being further adapted to execute a code for:

receiving an additional input of an interpolation factor L;
performing in each of a plurality of iterations said extracting first, second, third and fourth sub-vectors, said left shifting and replacing elements of the first sub-vector by elements of the third sub-vector for obtaining first and second dual left-shift vectors, said right shifting and replacing elements of the second sub-vector by elements of the fourth sub-vector for obtaining first and second dual right-shift vectors, and further performing the steps of:

obtaining from each of L phases of the FIR filter first and second multipliers, multiplying a first sum vector obtained from adding the first dual left-shift vector to the first dual right-shift vector by the first multiplier, and multiplying a second sum vector obtained from adding the second dual left-shift vector to the second dual right-shift vector by the second multiplier; and
for each of the L phases, adding to a phase accumulated vector comprising portions of the filtered data a sum of the multiplication results obtained for the phase;

and
multiplexing the filtered data obtained at the L phase accumulated vectors by alternate selection of elements therefrom.

**11.** A method for applying a Finite Impulse Response (FIR) filter, comprising:

receiving (500) a plurality of elements representing sequential values of a signal and a FIR filter;
calculating from the plurality of elements filtered data by performing the following in each of a plurality of iterations:

extracting (510, 520) from the plurality of elements first and second sub-vectors, a third sub-vector that succeeds the first sub-vector, and a fourth sub-vector that precedes the second sub-vector, wherein the first and second sub-vectors respectively comprise consecutive values of the signal, the second sub-vector comprises a sequence of elements starting at a location TAP_LEN+1 elements away further ahead of a first element of the first sub-vector, and TAP_LEN+1 denotes a total length of the FIR filter;
shifting (530) left the first sub-vector by at least one element and replacing elements at right-most locations thereof by elements of the third sub-vector to obtain first and second dual left-shift vectors, wherein the first and second dual left-shift vectors are obtained by shifting left the first sub-vector by one and two elements, respectively, and replacing one or two elements, respectively, at right-most locations thereof by elements of the third sub-vector;
shifting (540) right the second sub-vector by at least one element and replacing elements at left-most locations thereof by elements of the fourth sub-vector to obtain first and second dual right-shift vectors, wherein the first and second dual right-shift vectors are obtained by shifting right the first sub-vector by one and two elements, respectively, and replacing one or two elements, respectively, at left-most locations thereof by elements of the fourth sub-vector; and
adding (550) to an accumulated vector comprising portions of the filtered data from previous iterations a sum of vectors pair obtained as an outcome of:

multiplying (560) a sum of the first dual left-shift vector and the first dual right-shift vector with a multiplier from the FIR filter; and
multiplying (570) a sum of the second dual left-shift vector and the second dual right-shift vector with another multiplier from the FIR filter.

**12.** The method according to claim 11, wherein the FIR filter is symmetric and having a first length, wherein the first sub-vector and the second sub-vector are obtained at an interval of the first length, wherein a number of iterations in which the third sub-vector and the fourth sub-vector are obtained is determined as a function of the first length.

**13.** The method according to any of claims 11 to 12, wherein the first and second dual left-shift vectors are obtained by retrieving a first element of the third sub-vector at a rightward offset per a first left-shift parameter specified, and a second element of the third sub-vector at a rightward offset per a second left-shift parameter specified.

**14.** The method according to any of claims 11 to 13, wherein the first and second dual right-shift vectors are obtained by retrieving a first element of the fourth sub-vector at a leftward offset per a first right-shift parameter specified, and a second element of the fourth sub-vector at a leftward offset per a second right-shift parameter specified.

**15.** A computer program product for applying a Finite Impulse Response (FIR) filter, comprising:

a non-transitory computer readable storage medium;
program instructions for executing, by a processor, a method comprising:

receiving (500) a plurality of elements representing sequential values of a signal and a FIR filter;
calculating from the plurality of elements filtered data by performing the following in each of a plurality of iterations:

extracting (510, 520) from the plurality of elements first and second sub-vectors, a third sub-vector that succeeds the first sub-vector, and a fourth sub-vector that precedes the second sub-vector, wherein the first and second sub-vectors respectively comprise consecutive values of the signal, the second sub-vector comprises a sequence of elements starting at a location TAP_LEN+1 elements away further ahead of a first element of the first sub-vector, and TAP_LEN+1 denotes a total length of the FIR filter;
shifting (530) left the first sub-vector by at least one element and replacing elements at right-most locations thereof by elements of the third sub-vector to obtain first and second dual left-shift vectors, wherein the first and second dual left-shift vectors are obtained by shifting left the first sub-vector by one and two elements, respectively, and replacing one or two elements, respectively, at right-most locations thereof by elements of the third sub-vector;

shifting (540) right the second sub-vector by at least one element and replacing elements at left-most locations thereof by elements of the fourth sub-vector to obtain first and second dual right-shift vectors, wherein the first and second dual right-shift vectors are obtained by shifting right the first sub-vector by one and two elements, respectively, and replacing one or two elements, respectively, at left-most locations thereof by elements of the fourth sub-vector; and

adding (550) to an accumulated vector comprising portions of the filtered data from previous iterations a sum of vectors pair obtained as an outcome of:

> multiplying (560) a sum of the first dual left-shift vector and the first dual right-shift vector with a multiplier from the FIR filter; and
>
> multiplying (570) a sum of the second dual left-shift vector and the second dual right-shift vector with another multiplier from the FIR filter.

**Patentansprüche**

1. System zum Anwenden eines Endliche-Impulsantwort(FIR)-Filters, das Folgendes umfasst:

eine Verarbeitungsschaltung, die dafür ausgelegt ist, Code auszuführen zum:

Empfangen (500) mehrerer Elemente, die aufeinanderfolgende Werte eines Signals und eines FIR-Filters darstellen;

Berechnen, aus den mehreren Elementen, von gefilterten Daten, indem in jeder von mehreren Iterationen Folgendes durchgeführt wird:

> Extrahieren (510, 520), aus den mehreren Elementen, eines ersten und eines zweiten Teilvektors, eines dritten Teilvektors, der auf den ersten Teilvektor folgt, und eines vierten Teilvektors, der dem zweiten Teilvektor vorangeht, wobei der erste und der zweite Teilvektor jeweils aufeinanderfolgende Werte des Signals umfassen, der zweite Teilvektor eine Folge von Elementen umfasst, die an einer Stelle TAP_LEN+1 Elemente weiter entfernt vor einem ersten Element des ersten Teilvektors beginnt, und TAP_LEN+1 eine Gesamtlänge des FIR-Filters bezeichnet;
>
> Verschieben (530) des ersten Teilvektors nach links um mindestens ein Element und Ersetzen von Elementen an den äußersten rechten Stellen davon durch Elemente des dritten Teilvektors, um einen ersten und einen zweiten dualen Linksverschiebungsvektor zu erhalten, wobei der erste und der zweite duale Linksverschiebungsvektor erhalten werden, indem der erste Teilvektor um ein bzw. zwei Elemente nach links verschoben wird und ein bzw. zwei Elemente an den äußersten rechten Stellen davon durch Elemente des dritten Teilvektors ersetzt werden;
>
> Verschieben (540) des zweiten Teilvektors nach rechts um mindestens ein Element und Ersetzen von Elementen an den äußersten linken Stellen davon durch Elemente des vierten Teilvektors, um einen ersten und einen zweiten dualen Rechtsverschiebungsvektor zu erhalten, wobei der erste und der zweite duale Rechtsverschiebungsvektor erhalten werden, indem der erste Teilvektor um ein bzw. zwei Elemente nach rechts verschoben wird und ein bzw. zwei Elemente an den äußersten linken Stellen davon durch Elemente des vierten Teilvektors ersetzt werden; und
>
> Addieren (550), zu einem akkumulierten Vektor, der Teile der gefilterten Daten aus früheren Iterationen umfasst, einer Summe von Vektorpaaren, die als Ergebnis von Folgendem erhalten werden:
>
>> Multiplizieren (560) einer Summe aus dem ersten dualen Linksverschiebungsvektor und dem ersten dualen Rechtsverschiebungsvektor mit einem Multiplikator aus dem FIR-Filter; und
>>
>> Multiplizieren (570) einer Summe aus dem zweiten dualen Linksverschiebungsvektor und dem zweiten dualen Rechtsverschiebungsvektor mit einem anderen Multiplikator aus dem FIR-Filter.

2. System gemäß Anspruch 1, wobei der erste und der zweite duale Linksverschiebungsvektor Elemente des ersten Teilvektors umfassen, wie sie in Reaktion auf die einfache bzw. zweifache Linksverschiebung erhalten werden, wobei der erste und der zweite duale Rechtsverschiebungsvektor Elemente des zweiten Teilvektors umfassen, wie sie in Reaktion auf die einfache bzw. zweifache Rechtsverschiebung erhalten werden.

3. System gemäß einem der vorstehenden Ansprüche, wobei der FIR-Filter symmetrisch ist und eine erste Länge hat, wobei der erste Teilvektor und der zweite Teilvektor in einem Intervall der ersten Länge erhalten werden, wobei eine Anzahl von Iterationen, in denen der dritte Teilvektor und der vierte Teilvektor erhalten werden, als Funktion der ersten Länge bestimmt wird.

4. System gemäß einem der vorstehenden Ansprüche, wobei der erste Teilvektor und der zweite Teilvektor jeweils eine zweite Länge haben, wobei eine Anzahl von Iterationen, in denen der erste Teilvektor und der zweite Teilvektor erhalten werden, als Funktion eines Verhältnisses zwischen einer Länge des Signals und der zweiten Länge bestimmt wird.

5. System gemäß einem der vorstehenden Ansprüche, wobei der erste und der zweite duale Linksverschiebungsvektor erhalten werden, indem ein erstes Element des dritten Teilvektors mit einem Versatz nach rechts nach einem ersten angegebenen Linksverschiebungsparameter und ein zweites Element des dritten Teilvektors mit einem Versatz nach rechts nach einem zweiten angegebenen Linksverschiebungsparameter abgerufen werden.

6. System gemäß einem der vorstehenden Ansprüche, wobei der erste und der zweite duale Rechtsverschiebungsvektor erhalten werden, indem ein erstes Element des vierten Teilvektors mit einem Versatz nach links nach einem ersten angegebenen Rechtsverschiebungsparameter und ein zweites Element des vierten Teilvektors mit einem Versatz nach links nach einem zweiten angegebenen Rechtsverschiebungsparameter abgerufen werden.

7. System gemäß einem der vorstehenden Ansprüche, wobei zwei Multiplikatoren aus dem FIR-Filter bei einer j-ten Iteration erhalten werden, indem Elemente an (2j-1)-ten und (2j)-ten Stellen davon abgerufen werden.

8. System gemäß einem der vorstehenden Ansprüche, wobei der FIR-Filter ein Halbbandfilter ist, wobei die Verarbeitungsschaltung ferner dafür ausgelegt ist, Code auszuführen zum:

Erhalten einer ersten Teilsequenz des Signals, das Elemente an geraden Stellen davon umfasst;
Erhalten einer zweiten Teilsequenz des Signals, das Elemente an ungeraden Stellen davon umfasst;
Modifizieren des FIR-Filters durch Auswahl aller Elemente davon, die nicht Null sind;
Anwenden des modifizierten Filters sowohl auf die erste als auch auf die zweite Teilsequenz, um gerade und ungerade gefilterte Daten zu erhalten; und
Multiplexen der geraden und ungeraden gefilterten Daten durch abwechselnde Auswahl von Elementen daraus.

9. System gemäß einem der vorstehenden Ansprüche, wobei die Verarbeitungsschaltung ferner dafür ausgelegt ist, Code auszuführen zum:

Empfangen einer zusätzlichen Eingabe eines Reduktionsfaktors D;
Erhalten von D Teilsequenzen des Signals, die jeweils Elemente davon in Intervallen von D umfassen, wobei jede der D Teilsequenzen bei einem anderen Element beginnt, das aus den ersten D Elementen des Signals ausgewählt ist; und
für jede der D Teilsequenzen, Durchführen, in jeder von mehreren Iterationen, des Extrahierens eines ersten, zweiten, dritten und vierten Teilvektors, des Linksverschiebens und Ersetzens von Elementen des ersten Teilvektors durch Elemente des dritten Teilvektors, um einen ersten und einen zweiten dualen Linksverschiebungsvektor zu erhalten, des Rechtsverschiebens und Ersetzens von Elementen des zweiten Teilvektors durch Elemente des vierten Teilvektors, um einen ersten und einen zweiten dualen Rechtsverschiebungsvektor zu erhalten, und ferner Durchführen der Schritte:

Erhalten, aus jeder von D Phasen des FIR-Filters, eines ersten und eines zweiten Multiplikators, Multiplizieren eines ersten Summenvektors, der aus dem Addieren des ersten dualen Linksverschiebungsvektors zu dem ersten dualen Rechtsverschiebungsvektor erhalten wird, mit dem ersten Multiplikator und Multiplizieren eines zweiten Summenvektors, der aus dem Addieren des zweiten dualen Linksverschiebungsvektors zu dem zweiten dualen Rechtsverschiebungsvektor erhalten wird, mit dem zweiten Multiplikator; und
Addieren, zu dem akkumulierten Vektor, der Teile der gefilterten Daten umfasst, einer Summe der für jede der D Phasen erhaltenen Multiplikationsergebnisse.

10. System gemäß einem der vorstehenden Ansprüche, wobei die Verarbeitungsschaltung ferner dafür ausgelegt ist, Code auszuführen zum:

Empfangen einer zusätzlichen Eingabe eines Interpolationsfaktors L;

Durchführen, in jeder von mehreren Iterationen, des Extrahierens eines ersten, zweiten, dritten und vierten Teilvektors, des Linksverschiebens und Ersetzens von Elementen des ersten Teilvektors durch Elemente des dritten Teilvektors, um einen ersten und einen zweiten dualen Linksverschiebungsvektor zu erhalten, des Rechtsverschiebens und Ersetzens von Elementen des zweiten Teilvektors durch Elemente des vierten Teilvektors, um einen ersten und einen zweiten dualen Rechtsverschiebungsvektor zu erhalten, und ferner Durchführen der Schritte:

Erhalten, aus jeder von L Phasen des FIR-Filters, eines ersten und eines zweiten Multiplikators, Multiplizieren eines ersten Summenvektors, der aus dem Addieren des ersten dualen Linksverschiebungsvektors zu dem ersten dualen Rechtsverschiebungsvektor erhalten wird, mit dem ersten Multiplikator und Multiplizieren eines zweiten Summenvektors, der aus dem Addieren des zweiten dualen Linksverschiebungsvektors zu dem zweiten dualen Rechtsverschiebungsvektor erhalten wird, mit dem zweiten Multiplikator; und

für jede der L Phasen, Addieren, zu einem phasenakkumulierten Vektor, der Teile der gefilterten Daten umfasst, einer Summe der für die Phase erhaltenen Multiplikationsergebnisse; und

Multiplexen der gefilterten Daten, die an den L phasenakkumulierten Vektoren erhalten wurden, durch abwechselnde Auswahl von Elementen daraus.

**11.** Verfahren zum Anwenden eines Endliche-Impulsantwort (FIR, "Finite Impulse Response") -Filters, das Folgendes umfasst:

Empfangen (500) mehrerer Elemente, die aufeinanderfolgende Werte eines Signals und eines FIR-Filters darstellen;

Berechnen, aus den mehreren Elementen, von gefilterten Daten, indem in jeder von mehreren Iterationen Folgendes durchgeführt wird:

Extrahieren (510, 520), aus den mehreren Elementen, eines ersten und eines zweiten Teilvektors, eines dritten Teilvektors, der auf den ersten Teilvektor folgt, und eines vierten Teilvektors, der dem zweiten Teilvektor vorangeht, wobei der erste und der zweite Teilvektor jeweils aufeinanderfolgende Werte des Signals umfassen, der zweite Teilvektor eine Folge von Elementen umfasst, die an einer Stelle TAP_LEN+1 Elemente weiter entfernt vor einem ersten Element des ersten Teilvektors beginnt, und TAP_LEN+1 eine Gesamtlänge des FIR-Filters bezeichnet;

Verschieben (530) des ersten Teilvektors nach links um mindestens ein Element und Ersetzen von Elementen an den äußersten rechten Stellen davon durch Elemente des dritten Teilvektors, um einen ersten und einen zweiten dualen Linksverschiebungsvektor zu erhalten, wobei der erste und der zweite duale Linksverschiebungsvektor erhalten werden, indem der erste Teilvektor um ein bzw. zwei Elemente nach links verschoben wird und ein bzw. zwei Elemente an den äußersten rechten Stellen davon durch Elemente des dritten Teilvektors ersetzt werden;

Verschieben (540) des zweiten Teilvektors nach rechts um mindestens ein Element und Ersetzen von Elementen an den äußersten linken Stellen davon durch Elemente des vierten Teilvektors, um einen ersten und einen zweiten dualen Rechtsverschiebungsvektor zu erhalten, wobei der erste und der zweite duale Rechtsverschiebungsvektor erhalten werden, indem der erste Teilvektor um ein bzw. zwei Elemente nach rechts verschoben wird, und ein bzw. zwei Elemente an den äußersten linken Stellen davon durch Elemente des vierten Teilvektors ersetzt werden; und

Addieren (550), zu einem akkumulierten Vektor, der Teile der gefilterten Daten aus früheren Iterationen umfasst, einer Summe von Vektorpaaren, die als Ergebnis von Folgendem erhalten werden:

Multiplizieren (560) einer Summe aus dem ersten dualen Linksverschiebungsvektor und dem ersten dualen Rechtsverschiebungsvektor mit einem Multiplikator aus dem FIR-Filter; und

Multiplizieren (570) einer Summe aus dem zweiten dualen Linksverschiebungsvektor und dem zweiten dualen Rechtsverschiebungsvektor mit einem anderen Multiplikator aus dem FIR-Filter.

**12.** Verfahren gemäß Anspruch 11, wobei der FIR-Filter symmetrisch ist und eine erste Länge hat, wobei der erste Teilvektor und der zweite Teilvektor in einem Intervall der ersten Länge erhalten werden, wobei eine Anzahl von Iterationen, in denen der dritte Teilvektor und der vierte Teilvektor erhalten werden, als Funktion der ersten Länge bestimmt wird.

**13.** Verfahren gemäß einem der Ansprüche 11 bis 12, wobei der erste und der zweite duale Linksverschiebungsvektor erhalten werden, indem ein erstes Element des dritten Teilvektors mit einem Versatz nach rechts nach einem ersten angegebenen Linksverschiebungsparameter und ein zweites Element des dritten Teilvektors mit einem Versatz nach rechts nach einem zweiten angegebenen Linksverschiebungsparameter abgerufen werden.

14. Verfahren gemäß einem der Ansprüche 11 bis 13, wobei der erste und der zweite duale Rechtsverschiebungsvektor erhalten werden, indem ein erstes Element des vierten Teilvektors mit einem Versatz nach links nach einem ersten angegebenen Rechtsverschiebungsparameter und ein zweites Element des vierten Teilvektors mit einem Versatz nach links nach einem zweiten angegebenen Rechtsverschiebungsparameter abgerufen werden.

15. Computerprogrammprodukt zum Anwenden eines Endliche-Impulsantwort(FIR)-Filters, das Folgendes umfasst:

ein nicht-transitorisches computerlesbares Speichermedium;
Programmanweisungen zur Ausführung, durch einen Prozessor, eines Verfahrens, das Folgendes umfasst:

Empfangen (500) mehrerer Elemente, die aufeinanderfolgende Werte eines Signals und eines FIR-Filters darstellen;
Berechnen, aus den mehreren Elementen, von gefilterten Daten, indem in jeder von mehreren Iterationen Folgendes durchgeführt wird:

Extrahieren (510, 520), aus den mehreren Elementen, eines ersten und eines zweiten Teilvektors, eines dritten Teilvektors, der auf den ersten Teilvektor folgt, und eines vierten Teilvektors, der dem zweiten Teilvektor vorangeht, wobei der erste und der zweite Teilvektor jeweils aufeinanderfolgende Werte des Signals umfasst, der zweite Teilvektor eine Folge von Elementen umfasst, die an einer Stelle TAP_LEN+1 Elemente weiter entfernt vor einem ersten Element des ersten Teilvektors beginnt, und TAP_LEN+1 eine Gesamtlänge des FIR-Filters bezeichnet;
Verschieben (530) des ersten Teilvektors nach links um mindestens ein Element und Ersetzen von Elementen an den äußersten rechten Stellen davon durch Elemente des dritten Teilvektors, um einen ersten und einen zweiten dualen Linksverschiebungsvektor zu erhalten, wobei der erste und der zweite duale Linksverschiebungsvektor erhalten werden, indem der erste Teilvektor um ein bzw. zwei Elemente nach links verschoben wird und ein bzw. zwei Elemente an den äußersten rechten Stellen davon durch Elemente des dritten Teilvektors ersetzt werden;
Verschieben (540) des zweiten Teilvektors nach rechts um mindestens ein Element und Ersetzen von Elementen an den äußersten linken Stellen davon durch Elemente des vierten Teilvektors, um einen ersten und einen zweiten dualen Rechtsverschiebungsvektor zu erhalten, wobei der erste und der zweite duale Rechtsverschiebungsvektor erhalten werden, indem der erste Teilvektor um ein bzw. zwei Elemente nach rechts verschoben wird und ein bzw. zwei Elemente an den äußersten linken Stellen davon durch Elemente des vierten Teilvektors ersetzt werden;
Addieren (550), zu einem akkumulierten Vektor, der Teile der gefilterten Daten aus früheren Iterationen umfasst, einer Summe von Vektorpaaren, die als Ergebnis von Folgendem erhalten werden:

Multiplizieren (560) einer Summe aus dem ersten dualen Linksverschiebungsvektor und dem ersten dualen Rechtsverschiebungsvektor mit einem Multiplikator aus dem FIR-Filter; und
Multiplizieren (570) einer Summe aus dem zweiten dualen Linksverschiebungsvektor und dem zweiten dualen Rechtsverschiebungsvektor mit einem anderen Multiplikator aus dem FIR-Filter.

**Revendications**

1. Système permettant d'appliquer un filtre à réponse impulsionnelle finie (FIR), comprenant :
une circuiterie de traitement conçue pour exécuter un code permettant de :

recevoir (500) une pluralité d'éléments représentant des valeurs séquentielles d'un signal et un filtre FIR ;
calculer, à partir de la pluralité d'éléments, des données filtrées en réalisant les opérations suivantes dans chacune d'une pluralité d'itérations :

extraire (510, 520), de la pluralité d'éléments, des premier et deuxième sous-vecteurs, un troisième sous-vecteur qui succède au premier sous-vecteur, et un quatrième sous-vecteur qui précède le deuxième sous-vecteur, les premier et deuxième sous-vecteurs comprenant respectivement des valeurs consécutives du signal, le deuxième sous-vecteur comprenant une séquence d'éléments commençant à un emplacement situé à TAP_LEN+1 éléments plus loin qu'un premier élément du premier sous-vecteur, et TAP_LEN+1 désignant une longueur totale du filtre FIR ;

décaler (530) le premier sous-vecteur d'au moins un élément vers la gauche et remplacer les éléments situés au niveau d'emplacements les plus à droite de celui-ci par des éléments du troisième sous-vecteur afin d'obtenir des premier et second vecteurs doubles décalés vers la gauche, les premier et second vecteurs doubles décalés vers la gauche étant obtenus en décalant respectivement le premier sous-vecteur d'un et deux éléments vers la gauche et en remplaçant respectivement un ou deux éléments au niveau d'emplacements les plus à droite de celui-ci par des éléments du troisième sous-vecteur ;

décaler (540) le deuxième sous-vecteur d'au moins un élément vers la droite et remplacer les éléments situés au niveau d'emplacements les plus à gauche de celui-ci par des éléments du quatrième sous-vecteur afin d'obtenir des premier et second vecteurs doubles décalés vers la droite, les premier et second vecteurs doubles décalés vers la droite étant obtenus en décalant respectivement le premier sous-vecteur d'un et deux éléments vers la droite et en remplaçant respectivement un ou deux éléments au niveau d'emplacements les plus à gauche de celui-ci par des éléments du quatrième sous-vecteur ; et

ajouter (550), à un vecteur cumulé comprenant des parties des données filtrées provenant d'itérations précédentes, une somme de paires de vecteurs obtenue comme résultat des opérations consistant à :

multiplier (560) une somme du premier vecteur double décalé vers la gauche et du premier vecteur double décalé vers la droite par un multiplicateur provenant du filtre FIR ; et

multiplier (570) une somme du second vecteur double décalé vers la gauche et du second vecteur double décalé vers la droite par un autre multiplicateur provenant du filtre FIR.

2. Système selon la revendication 1, les premier et second vecteurs doubles décalés vers la gauche comprenant des éléments du premier sous-vecteur obtenus en réponse à un décalage vers la gauche respectivement une fois et deux fois, les premier et second vecteurs doubles décalés vers la droite comprenant des éléments du deuxième sous-vecteur obtenus en réponse à un décalage vers la droite respectivement une fois et deux fois.

3. Système selon l'une quelconque des revendications précédentes, le filtre FIR étant symétrique et présentant une première longueur, le premier sous-vecteur et le deuxième sous-vecteur étant obtenus à un intervalle de la première longueur, un nombre d'itérations au cours desquelles le troisième sous-vecteur et le quatrième sous-vecteur sont obtenus étant déterminé en fonction de la première longueur.

4. Système selon l'une quelconque des revendications précédentes, le premier sous-vecteur et le deuxième sous-vecteur présentant chacun une seconde longueur, un nombre d'itérations au cours desquelles le premier sous-vecteur et le deuxième sous-vecteur sont obtenus étant déterminé en fonction d'un rapport entre une longueur du signal et la seconde longueur.

5. Système selon l'une quelconque des revendications précédentes, les premier et second vecteurs doubles décalés vers la gauche étant obtenus en récupérant un premier élément du troisième sous-vecteur à un décalage vers la droite selon un premier paramètre spécifié de décalage vers la gauche et un second élément du troisième sous-vecteur à un décalage vers la droite selon un second paramètre spécifié de décalage vers la gauche.

6. Système selon l'une quelconque des revendications précédentes, les premier et second vecteurs doubles décalés vers la droite étant obtenus en récupérant un premier élément du quatrième sous-vecteur à un décalage vers la gauche selon un premier paramètre spécifié de décalage vers la droite et un second élément du quatrième sous-vecteur à un décalage vers la gauche selon un second paramètre spécifié de décalage vers la droite.

7. Système selon l'une quelconque des revendications précédentes, deux multiplicateurs du filtre FIR étant obtenus lors d'une $j^e$ itération en récupérant les éléments aux $(2j-1)^e$ et $(2j)^e$ emplacements de celui-ci.

8. Système selon l'une quelconque des revendications précédentes, le filtre FIR étant un filtre demi-bande, la circuiterie de traitement étant en outre conçue pour exécuter un code permettant de :

obtenir une première sous-séquence du signal, comprenant les éléments aux emplacements pairs de celle-ci ;

obtenir une seconde sous-séquence du signal, comprenant les éléments aux emplacements impairs de celle-ci ;

modifier le filtre FIR en sélectionnant tous ses éléments non nuls ;

appliquer le filtre modifié à chacune des première et seconde sous-séquences afin d'obtenir des données filtrées paires et impaires ; et
multiplexer les données filtrées paires et impaires par sélection alternée d'éléments parmi celles-ci.

9. Système selon l'une quelconque des revendications précédentes, la circuiterie de traitement étant en outre conçue pour exécuter un code permettant de :

recevoir une entrée supplémentaire d'un facteur de décimation D ;
obtenir D sous-séquences du signal, comprenant chacune des éléments de celui-ci à des intervalles de D, chacune des D sous-séquences commençant à un élément différent sélectionné parmi les D premiers éléments du signal ; et
pour chacune des D sous-séquences, réaliser, dans chacune d'une pluralité d'itérations, ladite extraction des premier, deuxième, troisième et quatrième sous-vecteurs, ledit décalage vers la gauche et ledit remplacement des éléments du premier sous-vecteur par les éléments du troisième sous-vecteur afin d'obtenir les premier et second vecteurs doubles décalés vers la gauche, ledit décalage vers la droite et ledit remplacement des éléments du deuxième sous-vecteur par les éléments du quatrième sous-vecteur afin d'obtenir les premier et second vecteurs doubles décalés vers la droite, et réaliser en outre les étapes consistant à :

obtenir, à partir de chacune des D phases du filtre FIR, des premier et second multiplicateurs, multiplier par le premier multiplicateur un premier vecteur somme obtenu en ajoutant le premier vecteur double de décalage vers la gauche au premier vecteur double de décalage vers la droite, et multiplier par le second multiplicateur un second vecteur somme obtenu en ajoutant le second vecteur double de décalage vers la gauche au second vecteur double de décalage vers la droite ; et
ajouter au vecteur cumulé, comprenant des parties des données filtrées, une somme des résultats de multiplication obtenus pour chacune des D phases.

10. Système selon l'une quelconque des revendications précédentes, la circuiterie de traitement étant en outre conçue pour exécuter un code permettant de :

recevoir une entrée supplémentaire d'un facteur d'interpolation L ;
réaliser, dans chacune d'une pluralité d'itérations, ladite extraction des premier, deuxième, troisième et quatrième sous-vecteurs, ledit décalage vers la gauche et ledit remplacement des éléments du premier sous-vecteur par les éléments du troisième sous-vecteur afin d'obtenir les premier et second vecteurs doubles décalés vers la gauche, ledit décalage vers la droite et ledit remplacement des éléments du deuxième sous-vecteur par les éléments du quatrième sous-vecteur afin d'obtenir les premier et second vecteurs doubles décalés vers la droite, et réaliser en outre les étapes consistant à :

obtenir, à partir de chacune des L phases du filtre FIR, des premier et second multiplicateurs, multiplier par le premier multiplicateur un premier vecteur somme obtenu en ajoutant le premier vecteur double de décalage vers la gauche au premier vecteur double de décalage vers la droite, et multiplier par le second multiplicateur un second vecteur somme obtenu en ajoutant le second vecteur double de décalage vers la gauche au second vecteur double de décalage vers la droite ; et
pour chacune des L phases, ajouter, à un vecteur cumulé de phase comprenant des parties des données filtrées, une somme des résultats de multiplication obtenus pour la phase ; et
multiplexer les données filtrées obtenues au niveau des L vecteurs cumulés de phase par sélection alternée d'éléments parmi celles-ci.

11. Procédé permettant d'appliquer un filtre à réponse impulsionnelle finie (FIR), comprenant les étapes consistant à :

recevoir (500) une pluralité d'éléments représentant des valeurs séquentielles d'un signal et un filtre FIR ;
calculer, à partir de la pluralité d'éléments, des données filtrées en réalisant les opérations suivantes dans chacune d'une pluralité d'itérations :

extraire (510, 520), de la pluralité d'éléments, des premier et deuxième sous-vecteurs, un troisième sous-vecteur qui succède au premier sous-vecteur, et un quatrième sous-vecteur qui précède le deuxième sous-vecteur, les premier et deuxième sous-vecteurs comprenant respectivement des valeurs consécutives du signal, le deuxième sous-vecteur comprenant une séquence d'éléments commençant à un emplacement situé à TAP_LEN+1 éléments plus loin qu'un premier élément du premier sous-vecteur, et TAP_LEN+1 désignant une longueur totale du filtre FIR ;

décaler (530) le premier sous-vecteur d'au moins un élément vers la gauche et remplacer les éléments situés au niveau d'emplacements les plus à droite de celui-ci par des éléments du troisième sous-vecteur afin d'obtenir des premier et second vecteurs doubles décalés vers la gauche, les premier et second vecteurs doubles décalés vers la gauche étant obtenus en décalant respectivement le premier sous-vecteur d'un et deux éléments vers la gauche et en remplaçant respectivement un ou deux éléments au niveau d'emplacements les plus à droite de celui-ci par des éléments du troisième sous-vecteur ;

décaler (540) le deuxième sous-vecteur d'au moins un élément vers la droite et remplacer les éléments situés au niveau d'emplacements les plus à gauche de celui-ci par des éléments du quatrième sous-vecteur afin d'obtenir des premier et second vecteurs doubles décalés vers la droite, les premier et second vecteurs doubles décalés vers la droite étant obtenus en décalant respectivement le premier sous-vecteur d'un et deux éléments vers la droite et en remplaçant respectivement un ou deux éléments au niveau d'emplacements les plus à gauche de celui-ci par des éléments du quatrième sous-vecteur ; et

ajouter (550), à un vecteur cumulé comprenant des parties des données filtrées provenant d'itérations précédentes, une somme de paires de vecteurs obtenue comme résultat des opérations consistant à :

multiplier (560) une somme du premier vecteur double décalé vers la gauche et du premier vecteur double décalé vers la droite par un multiplicateur provenant du filtre FIR ; et

multiplier (570) une somme du second vecteur double décalé vers la gauche et du second vecteur double décalé vers la droite par un autre multiplicateur provenant du filtre FIR.

12. Procédé selon la revendication 11, le filtre FIR étant symétrique et présentant une première longueur, le premier sous-vecteur et le deuxième sous-vecteur étant obtenus à un intervalle de la première longueur, un nombre d'itérations au cours desquelles le troisième sous-vecteur et le quatrième sous-vecteur sont obtenus étant déterminé en fonction de la première longueur.

13. Procédé selon l'une quelconque des revendications 11 et 12, les premier et second vecteurs doubles décalés vers la gauche étant obtenus en récupérant un premier élément du troisième sous-vecteur à un décalage vers la droite selon un premier paramètre spécifié de décalage vers la gauche et un second élément du troisième sous-vecteur à un décalage vers la droite selon un second paramètre spécifié de décalage vers la gauche.

14. Procédé selon l'une quelconque des revendications 11 à 13, les premier et second vecteurs doubles décalés vers la droite étant obtenus en récupérant un premier élément du quatrième sous-vecteur à un décalage vers la gauche selon un premier paramètre spécifié de décalage vers la droite et un second élément du quatrième sous-vecteur à un décalage vers la gauche selon un second paramètre spécifié de décalage vers la droite.

15. Produit-programme informatique permettant d'appliquer un filtre à réponse impulsionnelle finie (FIR), comprenant :

un support de stockage non transitoire lisible par ordinateur ;
des instructions de programme permettant d'exécuter, par un processeur, un procédé comprenant les étapes consistant à :

recevoir (500) une pluralité d'éléments représentant des valeurs séquentielles d'un signal et un filtre FIR ;
calculer, à partir de la pluralité d'éléments, des données filtrées en réalisant les opérations suivantes dans chacune d'une pluralité d'itérations :

extraire (510, 520), de la pluralité d'éléments, des premier et deuxième sous-vecteurs, un troisième sous-vecteur qui succède au premier sous-vecteur, et un quatrième sous-vecteur qui précède le deuxième sous-vecteur, les premier et deuxième sous-vecteurs comprenant respectivement des valeurs consécutives du signal, le deuxième sous-vecteur comprenant une séquence d'éléments commençant à un emplacement situé à TAP_LEN+1 éléments plus loin qu'un premier élément du premier sous-vecteur, et TAP_LEN+1 désignant une longueur totale du filtre FIR ;

décaler (530) le premier sous-vecteur d'au moins un élément vers la gauche et remplacer les éléments situés au niveau d'emplacements les plus à droite de celui-ci par des éléments du troisième sous-vecteur afin d'obtenir des premier et second vecteurs doubles décalés vers la gauche, les premier et second vecteurs doubles décalés vers la gauche étant obtenus en décalant respectivement le premier sous-vecteur d'un et deux éléments vers la gauche et en remplaçant respectivement un ou deux éléments au niveau d'emplacements les plus à droite de celui-ci par des éléments du troisième sous-vecteur ;

décaler (540) le deuxième sous-vecteur d'au moins un élément vers la droite et remplacer les éléments situés au niveau d'emplacements les plus à gauche de celui-ci par des éléments du quatrième sous-vecteur afin d'obtenir des premier et second vecteurs doubles décalés vers la droite, les premier et second vecteurs doubles décalés vers la droite étant obtenus en décalant respectivement le premier sous-vecteur d'un et deux éléments vers la droite et en remplaçant respectivement un ou deux éléments au niveau d'emplacements les plus à gauche de celui-ci par des éléments du quatrième sous-vecteur ; et ajouter (550), à un vecteur cumulé comprenant des parties des données filtrées provenant d'itérations précédentes, une somme de paires de vecteurs obtenue comme résultat des opérations consistant à :

multiplier (560) une somme du premier vecteur double décalé vers la gauche et du premier vecteur double décalé vers la droite par un multiplicateur provenant du filtre FIR ; et
multiplier (570) une somme du second vecteur double décalé vers la gauche et du second vecteur double décalé vers la droite par un autre multiplicateur provenant du filtre FIR.

**FIG. 1A**

EP 3 994 796 B1

FIG. 1B

```
for (i = 0; i < DATA_LEN; i++)
{
    LD.V512.UA.CP  // 1
    LD.V512.UA.CP  // 2
    for (j = 0; i < TAP_LEN; j++)
    {
        LD.V128.UA.CP  // 3
        LD.V128.UA.BCK.CP  // 4
        L32.IU  // 5
        ESHFTL.OFF.STP.CPX.V  // 6
        ESHFTR.OFF.STP.CPX.V  // 7
        ADD.DUAL.CPX.SAT.V  // 8
        MULA.DP.S40.V  // 9
    }
    SRA.W.SAT.S16.X.V  // 10
    ST.V512.IP  // 11
}
```

**FIG. 2A**

EP 3 994 796 B1

**FIG. 2B**

**ESHFTR.OFF.STP.CPX.V** Va, Vb, Vm, Vn, imm3

**FIR_MODE**

| | Step | |
|---|---|---|

**Vn**

| | e2 | | e1 | |
|---|---|---|---|---|

**Vm**

| 15 | ... | 2 | 1 | 0 |
|---|---|---|---|---|

**Va**

| e1 | 15 | ... | 2 | 1 |
|---|---|---|---|---|

**Vb**

| e2 | e1 | 15 | ... | 2 |
|---|---|---|---|---|

**FIG. 3**

EP 3 994 796 B1

ADD.DUAL (FIR_MODE.AVG = 1)

$(X_{n+j+1}+X_{T(n+j+1)})/2$     $(X_{n+j}+X_{T(n+j)})/2$

$h_1$     $h_0$

ADD to W[i+1]

ADD to W[i]

$(X_{n+j+2}+X_{T(n+j+2)})/2$     $(X_{n+j+1}+X_{T(n+j+1)})/2$

ADD.DUAL (FIR_MODE.AVG = 1)

**FIG. 4**

EP 3 994 796 B1

FIG. 5A

RECEIVE DATA SIGNAL, FIR FILTER & DECIMATION FACTOR D INPUT  500'

SPLIT DATA TO PHASES BY ELEMENTS SELECTION AT INTERVALS OF D  507'

EXTRACT FOR EACH PHASE FIRST & SECOND SUB-VECTORS  510'

EXTRACT THIRD & FOURTH SUB-VECTORS FROM DATA RESPECTIVELY OF FIRST & SECOND SUB-VECTORS FOR EACH PHASE  520'

OBTAIN FOR EACH PHASE FIRST & SECOND DUAL LEFT-SHIFT VECTORS FROM FIRST & THIRD SUB-VECTORS USING OFFSET D-1 & STEP D  530'

OBTAIN FOR EACH PHASE FIRST & SECOND DUAL RIGHT-SHIFT VECTORS FROM SECOND & FOURTH SUB-VECTORS USING OFFSET D-1 & STEP D  540'

ADD FIRST DUAL LEFT-SHIFT VECTOR TO FIRST DUAL RIGHT-SHIFT VECTOR & SECOND DUAL LEFT-SHIFT VECTOR TO SECOND DUAL RIGHT-SHIFT VECTOR  550'

MULTIPLY FIRST SUM VECTOR BY FIRST MULTIPLIER FROM FILTER & MULTIPLY SECOND SUM VECTOR BY SECOND MULTIPLIER FROM FILTER  560'

ADD SUM OF MULTIPLICATIONS RESULTS FOR EACH PHASE TO ACCUMULATED VECTOR  570'

# FIG. 5B

RECEIVE DATA SIGNAL & HALF-BAND FIR FILTER INPUT — 500"

MODIFY FILTER BY SELECTION OF EVERY NON-ZERO ELEMENT — 505"

SPLIT DATA TO ODD & EVEN ELEMENTS — 507"

EXTRACT FIRST & SECOND SUB-VECTORS FROM ODD/EVEN DATA — 510"

EXTRACT THIRD & FOURTH SUB-VECTORS FROM DATA RESPECTIVELY OF FIRST & SECOND SUB-VECTORS OF ODD/EVEN DATA — 520"

MULTIPLY ODD/EVEN FIRST SUM VECTOR BY MODIFIED FILTER TAP & MULTIPLY ODD/EVEN SECOND SUM VECTOR BY NEXT MODIFIED FILTER TAP — 560"

ADD SUM OF ODD/EVEN MULTIPLICATIONS RESULTS TO ODD/EVEN ACCUMULATED VECTOR — 570"

TRIM ODD/EVEN ACCUMULATED VECTOR TO WORKING SIZE & STORE IN ODD/EVEN RESULT — 580"

ALL DATA PROCESSED?
NO — YES

MULTIPLEX ODD/EVEN RESULTS BY ALTERNATE SELECTION & STORE IN RESULT — 585"

OUTPUT RESULT — 590"

**FIG. 5C**

RECEIVE DATA SIGNAL, FIR FILTER & INTERPOLATION FACTOR L INPUT — 500'''

EXTRACT FIRST & SECOND SUB-VECTORS FROM DATA — 510'''

EXTRACT THIRD & FOURTH SUB-VECTORS FROM DATA RESPECTIVELY OF FIRST & SECOND SUB-VECTORS — 520'''

OBTAIN FIRST & SECOND DUAL LEFT-SHIFT VECTORS FROM FIRST & THIRD SUB-VECTORS — 530'''

OBTAIN FIRST & SECOND DUAL RIGHT-SHIFT VECTORS FROM SECOND & FOURTH SUB-VECTORS — 540'''

ADD FIRST DUAL LEFT-SHIFT VECTOR TO FIRST DUAL RIGHT-SHIFT VECTOR & SECOND DUAL LEFT-SHIFT VECTOR TO SECOND DUAL RIGHT-SHIFT VECTOR — 550'''

MULTIPLY FIRST SUM VECTOR BY L PHASE TAPS FROM FILTER & MULTIPLY SECOND SUM VECTOR BY NEXT L PHASE TAPS FROM FILTER — 560'''

FOR EACH OF L PHASE TAPS ADD SUM OF MULTIPLICATIONS RESULTS TO PHASE ACCUMULATED VECTOR — 570'''

NO — ALL TAPS PROCESSED? — YES

TRIM L PHASE ACCUMULATED VECTORS TO WORKING SIZE, MULTIPLEX PHASE RESULTS BY ALTERNATE SELECTION & STORE IN RESULT — 580'''

NO — ALL DATA PROCESSED? — YES

OUTPUT RESULT — 590'''

**FIG. 5D**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017269832 A1